# EUROPEAN PATENT APPLICATION

(11) **EP 4 550 969 A1**
(43) Date of publication of application: **07.05.2025**
(21) Application number: 24191289.8
(22) Date of filing: 26.07.2024
(51) Int. Cl.: H10D 1/68, H10B 12/00

(54) **INTEGRATED CIRCUIT DEVICE**

(30) Priority: 01.11.2023 KR 20230149278
(71) Applicant: Samsung Electronics Co., Ltd, Suwon-si, Gyeonggi-do 16677 (KR)
(72) Inventor: KIM, Seyoung, 16677 Suwon-si (KR); KIM, Dahee, 16677 Suwon-si (KR); SONG, Hongseon, 16677 Suwon-si (KR); LEE, Wanggon, 16677 Suwon-si (KR); CHUNG, Sukjin, 16677 Suwon-si (KR); KIM, Beomjong, 16677 Suwon-si (KR)
(74) Representative: Marks & Clerk LLP

(57) **Abstract**

Provided is an integrated circuit device including a lower electrode (LE), a dielectric layer (120) on the lower electrode, an upper electrode (UE) facing the lower electrode with the dielectric layer therebetween, and an interfacial structure (140) between the dielectric layer and the upper electrode, wherein the interfacial structure includes a first interfacial layer (141a) and a second interfacial layer (141b), and a high band gap interfacial layer (143) between the first interfacial layer and the second interfacial layer, wherein a third band gap of the high band gap interfacial layer is greater than a first band gap of the first interfacial layer and is greater than a second band gap of the second interfacial layer.

## Description

### BACKGROUND

The inventive concept relates to an integrated circuit device, and more particularly, to an integrated circuit device including a capacitor.

With the development of electronic technology, the down-scaling of semiconductor devices is in rapid progress. Accordingly, patterns in the electronic devices are being further miniaturized. Accordingly, there is a need to develop a structure capable of reducing a leakage current in a capacitor having a fine size and maintaining desired electrical characteristics.

### SUMMARY

The present inventive concept provides an integrated circuit device including a capacitor structure capable of reducing a leakage current.

The task to be solved by the technical idea of the present inventive concept is not limited to the above-mentioned task, and other tasks not mentioned may be clearly understood by those of ordinary skill in the art from the following description.

According to some embodiments of the present inventive concept, there is provided an integrated circuit device including a lower electrode, a dielectric layer on the lower electrode, an upper electrode facing the lower electrode with the dielectric layer therebetween, and an interfacial structure between the dielectric layer and the upper electrode, wherein the interfacial structure includes a first interfacial layer and a second interfacial layer, and a high band gap interfacial layer between the first interfacial layer and the second interfacial layer, wherein a third band gap of the high band gap interfacial layer is greater than a first band gap of the first interfacial layer and is greater than a second band gap of the second interfacial layer. Optionally, at least one of the first interfacial layer and second interfacial layer may be a doped interfacial layer.

According to some embodiments of the present inventive concept, there is provided an integrated circuit device including a lower electrode, a dielectric layer on the lower electrode, an upper electrode facing the lower electrode with the dielectric layer therebetween, and an interfacial structure between the dielectric layer and the upper electrode, wherein the interfacial structure includes a first doped interfacial layer including a first metal oxide layer including a first dopant, and a high band gap interfacial layer on the first doped interfacial layer and having a second band gap greater than a first band gap of the first doped interfacial layer, wherein the first doped interfacial layer has one surface in contact with the dielectric layer or the upper electrode.

According to some embodiments of the present inventive concept, there is provided an integrated circuit device including a lower electrode, a dielectric layer on the lower electrode and including a silicon oxide layer or a first metal oxide layer including a first metal, an upper electrode facing the lower electrode with the dielectric layer therebetween, and an interfacial structure between the dielectric layer and the upper electrode, wherein the interfacial structure includes a plurality of second metal oxide layers including a second metal, and a plurality of third metal oxide layers between a pair of second metal oxide layers among the plurality of second metal oxide layers and including a third metal, wherein the plurality of third metal oxide layers have a band gap of 3.5 eV to 9.0 eV.

At least some of the above and other features of the invention are set out in the claims.

### BRIEF DESCRIPTION OF THE DRAWINGS

Embodiments of the present inventive concept will be more clearly understood from the following detailed description taken in conjunction with the accompanying drawings in which:
FIG. 1 is a cross-sectional view illustrating a capacitor structure of an integrated circuit device according to some embodiments;
FIG. 2A is a cross-sectional view illustrating a capacitor structure of an integrated circuit device according to some embodiments;
FIG. 2B is a cross-sectional view illustrating a capacitor structure of an integrated circuit device according to some embodiments;
FIG. 2C is a cross-sectional view illustrating a capacitor structure of an integrated circuit device according to some embodiments;
FIG. 3 is a cross-sectional view illustrating a capacitor structure of an integrated circuit device according to some embodiments;
FIG. 4A is a cross-sectional view illustrating a capacitor structure of an integrated circuit device according to some embodiments;
FIG. 4B is a cross-sectional view illustrating a capacitor structure of an integrated circuit device according to some embodiments;
FIG. 4C is a cross-sectional view illustrating a capacitor structure of an integrated circuit device according to some embodiments;
FIG. 5A is a layout diagram illustrating an integrated circuit device according to some embodiments;
FIG. 5B is a cross-sectional view taken along line A -A' of FIG. 5A;
FIGS. 6A and 6B are cross-sectional views illustrating a method of manufacturing a capacitor structure of an integrated circuit device according to some embodiments;
FIGS. 7A and 7B are cross-sectional views illustrating a method of manufacturing a capacitor structure of an integrated circuit device according to some embodiments; and
FIGS. 8 to 14 are cross-sectional views illustrating a process order to explain a method of manufacturing an integrated circuit device according to some embodiments of the present inventive concept.

### DETAILED DESCRIPTION

Hereinafter, embodiments of the present inventive concept will be described in detail with reference to the accompanying drawings. The same reference numerals are used for the same components in the drawings, and redundant descriptions thereof will be omitted.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, spatially relative terms, such as "beneath," "below," "lower," "above," "upper," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein may be interpreted accordingly. It will be understood that when an element or layer is referred to as being "connected to", or "coupled to" another element or layer, it may be directly on, connected to, or coupled to the other element or layer, or one or more intervening elements or layers may be present. In contrast, when an element is referred to as being "directly coupled," "directly connected," or "directly responsive" to, or "directly on," another element, there are no intervening elements present. In addition, "electrical connection" conceptually includes a physical connection and a physical disconnection.

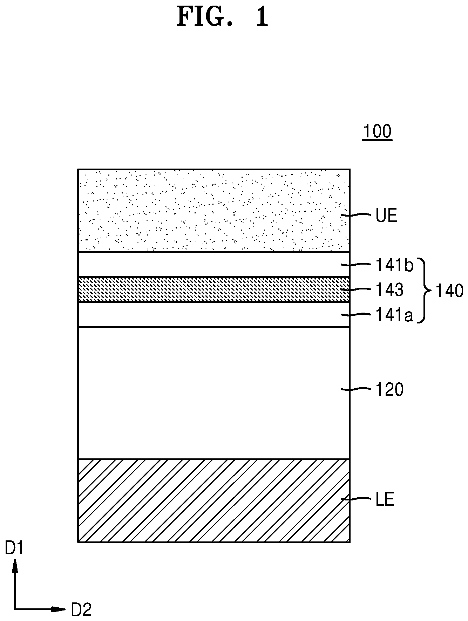

FIG. 1 is a cross-sectional view illustrating a capacitor structure 100 of an integrated circuit device according to some embodiments.

Referring to FIG. 1, an integrated circuit device may include a capacitor structure 100 formed on a substrate.

The substrate may include a semiconductor element including an element such as Si or Ge, or a compound semiconductor including a compound such as SiC, GaAs, InAs, and/or InP. The substrate may include a semiconductor substrate, at least one insulating layer formed on the semiconductor substrate, or structures including at least one conductive region. The conductive region may include, for example, an impurity-doped well or an impurity-doped structure. In some embodiments, the substrate may have various device isolation structures such as a shallow trench isolation (STI) structure.

The capacitor structure 100 is arranged on the substrate and may be electrically connected to a transistor formed on the substrate and/or in the substrate. The capacitor structure 100 may include a lower electrode LE, a dielectric layer 120, an interfacial structure 140, and an upper electrode UE sequentially stacked in a first direction D1. The first direction D1 may be defined as a direction perpendicular to one surface of the upper electrode UE facing the dielectric layer 120, and a second direction D2 may be defined as a direction parallel to one surface of the upper electrode UE facing the dielectric layer 120.

The lower electrode LE and the upper electrode UE may face each other with the dielectric layer 120 and the interfacial structure 140 therebetween.

In some embodiments, each of the lower electrode LE and the upper electrode UE may include a metal-containing or metal-including layer or doped polysilicon. The lower electrode LE may include a metal layer, a conductive metal oxide layer, a conductive metal nitride layer, a conductive metal oxynitride layer, or a combination thereof. In some embodiments, the lower electrode LE may include a metal such as titanium (Ti), niobium (Nb), cobalt (Co), tin (Sn), ruthenium (Ru), tungsten (W), a nitride including the metal, or an oxide including the metal. In some embodiments, the lower electrode LE may include NbN, TiN, TaN, CoN, SnO₂, or a combination thereof. In some embodiments, the lower electrode LE may include TaN, TiAlN, TaAlN, W, Ru, RuO₂, SrRuO₃, Ir, IrO₂, Pt, PtO, SRO(SrRuO₃), BSRO((Ba, Sr)RuO₃), CRO(CaRuO₃), LSCO(La, Sr)CoO₃), or a combination thereof. However, the material of the lower electrode LE is not limited to the above-described example. The upper electrode UE may include a metal layer, a conductive metal oxide layer, a conductive metal nitride layer, a conductive metal oxynitride layer, or a combination thereof. In some embodiments, the upper electrode UE may include a metal such as titanium (Ti), niobium (Nb), vanadium (V), molybdenum (Mo), or tungsten (W), or nitride including the metal. In some embodiments, the upper electrode UE may include TiN, NbN, VN, MoN, WN, or a combination thereof.

The dielectric layer 120 may have a first band gap. In some embodiments, a thickness of the dielectric layer 120 may be between about 0 Å and about 60 Å (e.g. may be between 0 Å and 60 Å) in the first direction D1.

The interfacial structure 140 may be disposed between the dielectric layer 120 and the upper electrode UE. In some embodiments, a thickness of the interfacial structure 140 may be between about 1 Å to about 30 Å (e.g. between 1 Å and 30 Å), between about 1 Å to about 25 Å (e.g. between 1 Å and 25 Å), between about 1 Å to about 20 Å (e.g. between 1 Å and 20 Å), between about 1 Å to about 15 Å (e.g. between 1 Å and 15 Å), between about 1 Å to about 10 Å (e.g. between 1 Å and 10 Å), or between about 1 Å to about 5 Å (e.g. between 1 Å and 5 Å), in the first direction D1.

The interfacial structure 140 may have a multilayer structure including a plurality of layers. In some embodiments, the interfacial structure 140 may include a plurality of interfacial layers, for example, a first interfacial layer 141a and a second interfacial layer 141b and a high band gap interfacial layer 143 arranged between the plurality of first interfacial layers 141a and the second interfacial layer 141b. For example, the first interfacial layer 141a may be arranged on the dielectric layer 120, the high band gap interfacial layer 143 may be arranged on the first interfacial layer 141a, and the second interfacial layer 141b may be arranged on the high band gap interfacial layer 143. The first interfacial layer 141a may be disposed between the dielectric layer 120 and the high band gap interfacial layer 143, and the second interfacial layer 141b may be disposed between the high band gap interfacial layer 143 and the upper electrode UE.

Each of the first interfacial layer 141a and the second interfacial layer 141b may have a second band gap, and the high band gap interfacial layer 143 may have a third band gap. In this case, the second band gap of each of the first interfacial layers 141a and the second interfacial layer 141b may be smaller than a first band gap of the dielectric layer 120, and the third band gap of the high band gap interfacial layer 143 may be larger than the second band gap of each of the first interfacial layer 141a and the second interfacial layer 141b.

In some embodiments, the first band gap of the dielectric layer 120 and the third band gap of the high band gap interfacial layer 143 may be the same. In some embodiments, the first band gap of the dielectric layer 120 and the third band gap of the high band gap interfacial layer 143 may be different from each other.

In some embodiments, the dielectric layer 120 may include a silicon oxide layer, a silicon nitride layer, or a first metal oxide layer including a first metal. Each of the first interfacial layer 141a and the second interfacial layer 141b may include a second metal oxide layer including a second metal. The high band gap interfacial layer 143 may include a third metal oxide layer including a third metal. Each of the dielectric layer 120, the first interfacial layer 141a and the second interfacial layer 141b, and the high band gap interfacial layer 143 may have a single layer structure including one layer or a multilayer structure including a plurality of layers.

In this case, a correlation may be formed in which a band gap of the second metal oxide layer is smaller than that of the first metal oxide layer and a band gap of the third metal oxide layer is larger than that of the second metal oxide layer.

According to the correlation between the band gaps of the first metal oxide layer, the second metal oxide layer, and the third metal oxide layer, the first metal, the second metal, and the third metal may be selected from hafnium (Hf), zirconium (Zr), aluminum (Al), lanthanum (La), tantalum (Ta), yttrium (Y), strontium (Sr), titanium (Ti), cobalt (Co), vanadium (V), copper (Cu), tantalum (Ta), niobium (Nb), tin (Sn), molybdenum (Mo), tungsten (W), barium (Ba), cerium (Ce), and/or a combination thereof, but are not limited thereto.

For example, the first metal oxide layer may have a band gap greater than or equal to about 3.5 eV and less than about 9.0 eV (e.g. greater than or equal to 3.5 eV and less than 9.0 eV), the second metal oxide layer may have a band gap greater than or equal to about 1.0 eV and less than about 3.5 eV (e.g. greater than or equal to 1.0 eV and less than 3.5 eV), and the third metal oxide layer may have a band gap greater than or equal to about 3.5 eV and less than about 9.0 eV (e.g. greater than or equal to 3.5 eV and less than 9.0 eV).

For example, the first metal may include at least one selected from hafnium (Hf), zirconium (Zr), aluminum (Al), lanthanum (La), tantalum (Ta), and/or yttrium (Y), the second metal may include at least one selected from titanium (Ti), cobalt (Co), tungsten (W), vanadium (V), copper (Cu), and/or niobium (Nb), and the third metal may include at least one selected from tantalum (Ta), niobium (Nb), tin (Sn), molybdenum (Mo), and/or tungsten (W). In some embodiments, the first metal, the second metal, and the third metal may be the same. In some embodiments, the first metal, the second metal, and the third metal may be different from each other.

For example, the dielectric layer 120 may include HfO₂, ZrO₂, Al₂O₃, La₂O₃, Ta₂O₅, Y₂O₃, or a combination thereof, but is not limited thereto. Each of the first interfacial layer 141a and the second interfacial layer 141b may include a titanium oxide layer, a cobalt oxide layer, a tungsten oxide layer, a vanadium oxide layer, a copper oxide layer, a niobium oxide layer, or a combination thereof, but is not limited thereto. The high band gap interfacial layer 143 may include a tantalum oxide layer, a niobium oxide layer, a tin oxide layer, a molybdenum oxide layer, a tungsten oxide layer, or a combination thereof, but is not limited thereto.

In some embodiments, the first interfacial layer 141a and the second interfacial layer 141b may include different metals. In some embodiments, the first interfacial layer 141a and the second interfacial layer 141b may include the same metal. In some embodiments, the first interfacial layer 141a may include a titanium oxide layer, but the second interfacial layer 141b may include a cobalt oxide layer. In some embodiments, the first interfacial layer 141a and the second interfacial layer 141b may include a titanium oxide layer.

In the interfacial structure 140, when the first interfacial layer 141a and the second interfacial layer 141b are not disposed between the high band gap interfacial layer 143 and the dielectric layer 120, and between the high band gap interfacial layer 143 and the upper electrode UE, respectively, the equilibrium oxide thickness (EOT) of the interfacial structure 140 may increase. In other words, when the high band gap interfacial layer 143 directly contacts the dielectric layer 120 or the upper electrode UE, the equilibrium oxide thickness of the interfacial structure 140 may increase. In some embodiments, the first interfacial layer 141a and the second interfacial layer 141b may be disposed between the dielectric layer 120 and the high band gap interfacial layer 143, and between the upper electrode UE and the high band gap interfacial layer 143, respectively, to prevent an excessive increase in the equilibrium oxide thickness of the interfacial structure 140. The dielectric layer 120 and the high band gap interfacial layer 143 may be spaced apart from each other by the first interfacial layer 141a, and the upper electrode UE and the high band gap interfacial layer 143 may be spaced apart from each other by the second interfacial layer 141b.

As the ratio of the high band gap interfacial layer 143 in the interfacial structure 140 increases, the equilibrium oxide thickness of the interfacial structure 140 may increase. In some embodiments, to prevent an excessive increase in the equilibrium oxide thickness of the interfacial structure 140, the ratio of the high band gap interfacial layer 143 in the interfacial structure 140 may be limited to more than about 0% and less than or equal to about 61% (e.g. to more than 0% and less than or equal to 61%). The total ratio of the first interfacial layer 141a and the second interfacial layer 141b in the interfacial structure 140 may be limited to about 39% or more but less than about 100% (e.g. to greater than or equal to 39% and less than to 100%).

According to some embodiments of the present inventive concept, the interfacial structure 140 includes a high band gap interfacial layer 143 having a relatively large band gap to reduce leakage current, but may relatively reduce an equilibrium oxide thickness by including first interfacial layers 141a and the second interfacial layer 141b disposed between the dielectric layer 120 and the high band gap interfacial layer 143, and between the upper electrode UE and the high band gap interfacial layer 143, respectively.

In addition, according to some embodiments of the present inventive concept, since the dielectric layer 120, each of the first interfacial layer 141a and the second interfacial layer 141b, and the high band gap interfacial layer 143 have a band gap distribution as described above, leakage current may be further reduced. Due to the energy barrier due to the difference in energy level existing between the low bandgap interfacial layer and the high bandgap interfacial layer, it is difficult to move electrons, thereby further reducing leakage current. Accordingly, the electrical characteristics of the capacitor structure are improved.

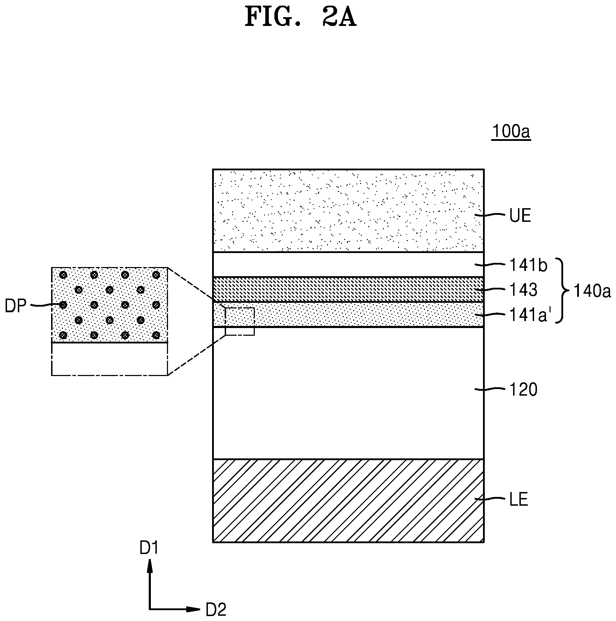

FIG. 2A is a cross-sectional view illustrating a capacitor structure 100a of an integrated circuit device according to some embodiments. Since the capacitor structure 100a is generally similar to the capacitor structure 100 described in FIG. 1, except that the interfacial structure 140a is included instead of the interfacial structure 140, the difference between the capacitor structure 100 and the capacitor structure 100a will be mainly described below.

Referring to FIG. 2A, an integrated circuit device may include a capacitor structure 100a formed on a substrate.

The capacitor structure 100a may include a lower electrode LE, a dielectric layer 120 on the lower electrode LE, an upper electrode UE, and an interfacial structure 140a between the dielectric layer 120 and the upper electrode UE. In some embodiments, a thickness of the interfacial structure 140a may be between about 1 Å to about 30 Å (e.g. between 1 Å and 30 Å), between about 1 Å to about 25 Å (e.g. between 1 Å and 25 Å), between about 1 Å to about 20 Å (e.g. between 1 Å and 20 Å), between about 1 Å to about 15 Å (e.g. between 1 Å and 15 Å), between about 1 Å to about 10 Å (e.g. between 1 Å and 10 Å), or between about 1 Å to about 5 Å (e.g. between 1 Å and 5 Å), in the first direction D1.

The interfacial structure 140a may have a multilayer structure including a plurality of layers. In some embodiments, the interfacial structure 140a may include a first doped interfacial layer 141a', a second interfacial layer 141b, and a high band gap interfacial layer 143 disposed between the first doped interfacial layer 141a' and the second interfacial layer 141b.

For example, the first doped interfacial layer 141a' may be arranged on the dielectric layer 120, the high band gap interfacial layer 143 may be arranged on the first doped interfacial layer 141a', and the second interfacial layer 141b may be arranged on the high band gap interfacial layer 143. In some embodiments, the first doped interfacial layer 141a' may be disposed between the dielectric layer 120 and the high band gap interfacial layer 143, and the second interfacial layer 141b may be disposed between the high band gap interfacial layer 143 and the upper electrode UE.

The dielectric layer 120 may have a first band gap, the first doped interfacial layer 141a' may have a second band gap, the second interfacial layer 141b may have a third band gap, and the high band gap interfacial layer 143 may have a fourth band gap. In this case, the second band gap of the first doped interfacial layer 141a' and the third band gap of the second interfacial layer 141b may be smaller than the first band gap of the dielectric layer 120, and the fourth band gap of the high band gap interfacial layer 143 may be larger than the second band gap of the first doped interfacial layer 141a' and the third band gap of the second interfacial layer 141b.

In some embodiments, the first band gap of the dielectric layer 120 and the fourth band gap of the high band gap interfacial layer 143 may be the same. In some embodiments, the first band gap of the dielectric layer 120 and the fourth band gap of the high band gap interfacial layer 143 may be different from each other.

In some embodiments, the dielectric layer 120 may include a silicon oxide layer, a silicon nitride layer, or a first metal oxide layer including a first metal. The second interfacial layer 141b and the first doped interfacial layer 141a' may include a second metal oxide layer including a second metal. The high band gap interfacial layer 143 may include a third metal oxide layer including a third metal. Each of the dielectric layer 120, the first doped interfacial layer 141a', the second interfacial layer 141b, and the high band gap interfacial layer 143 may have a single layer structure including one layer or a multilayer structure including a plurality of layers.

In this case, a correlation may be formed in which a band gap of the second metal oxide layer is smaller than that of the first metal oxide layer and a band gap of the third metal oxide layer is larger than that of the second metal oxide layer.

According to the correlation between the band gaps of the first metal oxide layer, the second metal oxide layer, and the third metal oxide layer, the first metal, the second metal, and the third metal may be selected from hafnium (Hf), zirconium (Zr), aluminum (Al), lanthanum (La), tantalum (Ta), yttrium (Y), strontium (Sr), titanium (Ti), cobalt (Co), vanadium (V), copper (Cu), tantalum (Ta), niobium (Nb), tin (Sn), molybdenum (Mo), tungsten (W), barium (Ba), cerium (Ce), and/or a combination thereof, but are not limited thereto.

Details of the first metal, the second metal, and the third metal are substantially the same as those described with respect to the first metal, the second metal, and the third metal in FIG. 1.

For example, the first doped interfacial layer 141a' may include, but is not limited to, a titanium oxide layer, a cobalt oxide layer, a tungsten oxide layer, a vanadium oxide layer, a copper oxide layer, a niobium oxide layer, or a combination thereof. The second interfacial layer 141b may include a titanium oxide layer, a cobalt oxide layer, a tungsten oxide layer, a vanadium oxide layer, a copper oxide layer, a niobium oxide layer, or a combination thereof, but is not limited thereto. The dielectric layer 120 and the high band gap interfacial layer 143 may include substantially the same material as the material illustrated for configuring the dielectric layer 120 and the high band gap interfacial layer 143 in FIG. 1.

In some embodiments, the first doped interfacial layer 141a' and the second interfacial layer 141b may include different metals. In some embodiments, the first doped interfacial layer 141a' and the second interfacial layer 141b may include the same metal. As some embodiments, the first doped interfacial layer 141a' may include a titanium oxide layer, and the second interfacial layer 141b may include a cobalt oxide layer. In some embodiments, the first doped interfacial layer 141a' may include a titanium oxide layer, and the second interfacial layer 141b may include a titanium oxide layer.

In some embodiments, dopants DP may include a metal that acts as an n-type doping effect. In some embodiments, each of the dopants DP may have a pentavalent valence state. For example, the dopants DP may include nitrogen (N), vanadium (V), copper (Cu), niobium (Nb), tantalum (Ta), antimony (Sb), phosphorus (P), or a combination thereof, but is not limited thereto.

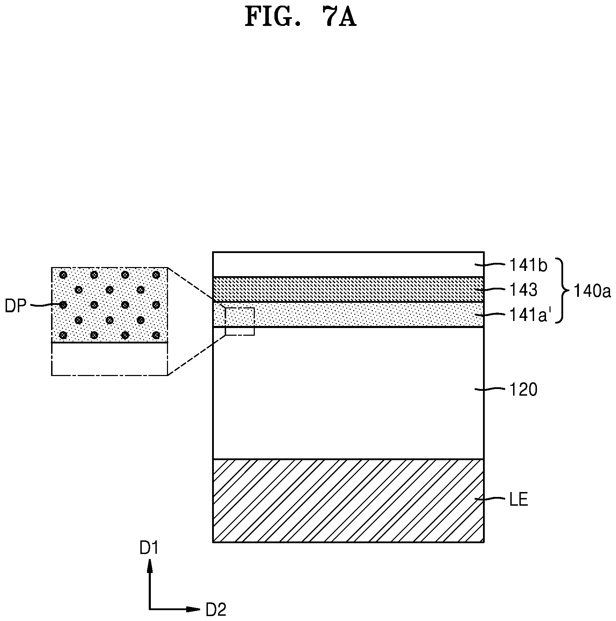

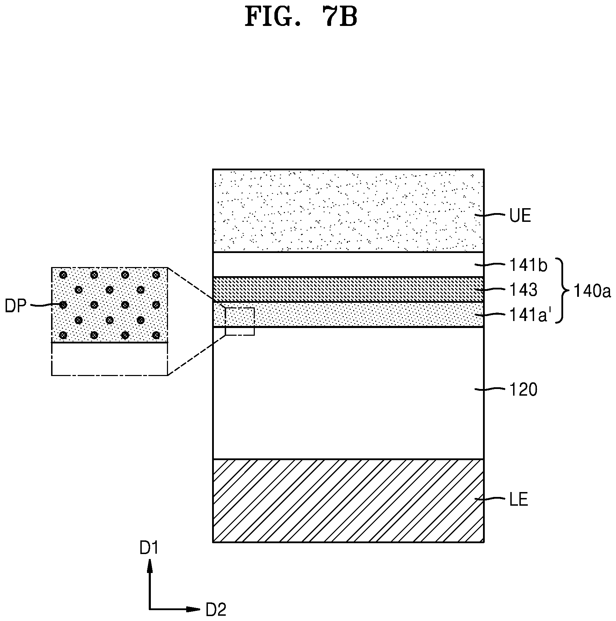

As illustrated in FIG. 2A, the dopants DP may be uniformly distributed in the first doped interfacial layer 141a'. The first doped interfacial layer 141a' including uniformly distributed dopants DP may be deposited by using an atomic layer deposition (ALD) method. Although not shown, in some embodiments, the dopants DP may be included in the first doped interfacial layer 141a' in the form of thin films. For example, the first doped interfacial layer 141a' may have a structure where thin films including dopants DP are attached onto a metal oxide layer forming the first doped interfacial layer 141a'. The first doped interfacial layer 141a' including dopants DP attached in the form of thin films may be deposited using a super cycle method. A more detailed manufacturing process of the first doped interfacial layer 141a' will be described later with reference to FIGS. 7A and 7B.

In some embodiments, to prevent an excessive increase in the equilibrium oxide thickness of the interfacial structure 140a, the total ratio of the high band gap interfacial layer 143a in the interfacial structure 140a may be limited to more than about 0% and less than or equal to about 61% (e.g. more than 0% and less than or equal to 61%). The total ratio of the first doped interfacial layer 141a' and the second interfacial layer 141b in the interfacial structure 140a may be limited to about 39% or more and less than about 100% (e.g. greater than or equal to 39% and less than 100%).

Since the first doped interfacial layer 141a' includes the dopants DP, the equilibrium oxide thickness of the interfacial structure 140a may be reduced, and the degree of integration of the integrated circuit device may be improved.

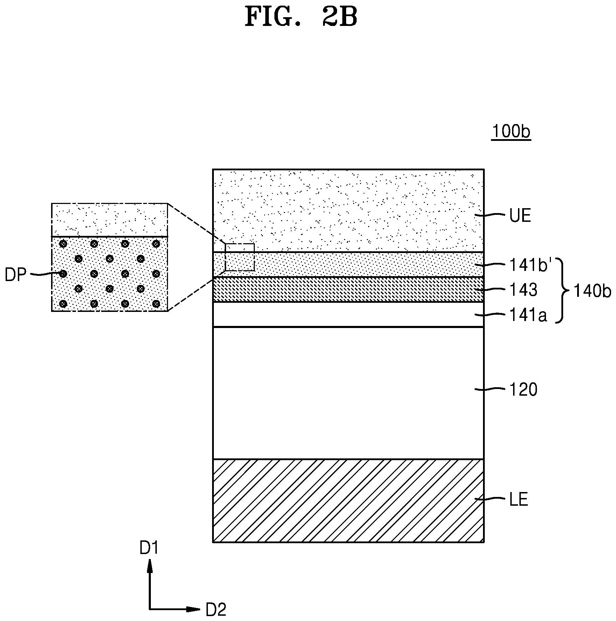

FIG. 2B is a cross-sectional view illustrating a capacitor structure 100b of an integrated circuit device according to some embodiments. Since the capacitor structure 100b is generally similar to the capacitor structure 100a described in FIG. 2A, except that the interfacial structure 140b is included instead of the interfacial structure 140a, the difference between the capacitor structure 100a and the capacitor structure 100b will be mainly described below.

Referring to FIG. 2B, an integrated circuit device may include a capacitor structure 100b formed on a substrate.

The capacitor structure 100b may include a lower electrode LE, a dielectric layer 120 on the lower electrode LE, an upper electrode UE, and an interfacial structure 140b between the dielectric layer 120 and the upper electrode UE. In some embodiments, a thickness of the interfacial structure 140b may be between about 1 Å to about 30 Å (e.g. between 1 Å and 30 Å), between about 1 Å to about 25 Å (e.g. between 1 Å and 25 Å), between about 1 Å to about 20 Å (e.g. between 1 Å and 20 Å), between about 1 Å to about 15 Å (e.g. between 1 Å and 15 Å), between about 1 Å to about 10 Å (e.g. between 1 Å and 10 Å), or between about 1 Å to about 5 Å (e.g. between 1 Å and 5 Å), in the first direction D1.

The interfacial structure 140b may have a multilayer structure including a plurality of layers. In some embodiments, the interfacial structure 140b may include an interfacial layer 141a, a second doped interfacial layer 141b', and a high band gap interfacial layer 143 disposed between the first interfacial layer 141a and the second doped interfacial layer 141b'.

For example, the first interfacial layer 141a may be arranged on the dielectric layer 120, the high band gap interfacial layer 143 may be arranged on the first interfacial layer 141a, and the second doped interfacial layer 141b' may be arranged on the high band gap interfacial layer 143. In some embodiments, the first interfacial layer 141a may be disposed between the dielectric layer 120 and the high band gap interfacial layer 143, and the second doped interfacial layer 141b' may be disposed between the high band gap interfacial layer 143 and the upper electrode UE.

The dielectric layer 120 may have a first band gap, the first interfacial layer 141a may have a second band gap, the second doped interfacial layer 141b' may have a third band gap, and the high band gap interfacial layer 143 may have a fourth band gap. In this case, the second band gap of the first interfacial layer 141a and the third band gap of the second doped interfacial layer 141b' may be smaller than the first band gap of the dielectric layer 120, and the fourth band gap of the high band gap interfacial layer 143 may be larger than the second band gap of the first interfacial layer 141a and the third band gap of the second doped interfacial layer 141b'.

In some embodiments, the first band gap of the dielectric layer 120 and the fourth band gap of the high band gap interfacial layer 143 may be the same. In some embodiments, the first band gap of the dielectric layer 120 and the fourth band gap of the high band gap interfacial layer 143 may be different from each other.

In some embodiments, the dielectric layer 120 may include a silicon oxide layer, a silicon nitride layer, or a first metal oxide layer including a first metal. The first interfacial layer 141a and the second doped interfacial layer 141b' may include a second metal oxide layer including a second metal. The high band gap interfacial layer 143 may include a third metal oxide layer including a third metal. Each of the dielectric layer 120, the first interfacial layer 141a, the second doped interfacial layer 141b', and the high band gap interfacial layer 143 may have a single layer structure including one layer or a multilayer structure including a plurality of layers.

In this case, a correlation may be formed in which a band gap of the second metal oxide layer is smaller than that of the first metal oxide layer and a band gap of the third metal oxide layer is larger than that of the second metal oxide layer.

According to the correlation between the band gaps of the first metal oxide layer, the second metal oxide layer, and the third metal oxide layer, the first metal, the second metal, and the third metal may be selected from hafnium (Hf), zirconium (Zr), aluminum (Al), lanthanum (La), tantalum (Ta), yttrium (Y), strontium (Sr), titanium (Ti), cobalt (Co), vanadium (V), copper (Cu), tantalum (Ta), niobium (Nb), tin (Sn), molybdenum (Mo), tungsten (W), barium (Ba), cerium (Ce), and/or a combination thereof, but are not limited thereto.

Details of the first metal, the second metal, and the third metal are substantially the same as those described with respect to the first metal, the second metal, and the third metal in FIG. 1.

For example, the first interfacial layer 141a may include a titanium oxide layer, a cobalt oxide layer, a tungsten oxide layer, a vanadium oxide layer, a copper oxide layer, a niobium oxide layer, or a combination thereof, but is not limited thereto. The second doped interfacial layer 141b' may include, but is not limited to, a titanium oxide layer, a cobalt oxide layer, a tungsten oxide layer, a vanadium oxide layer, a copper oxide layer, a niobium oxide layer, or a combination thereof. The dielectric layer 120 and the high band gap interfacial layer 143 may include substantially the same material as the material illustrated for configuring the dielectric layer 120 and the high band gap interfacial layer 143 in FIG. 1.

In some embodiments, the first interfacial layer 141a and the second doped interfacial layer 141b' may include different metals. In some embodiments, the first interfacial layer 141a and the second doped interfacial layer 141b' may include the same metal. In some embodiments, the first interfacial layer 141a may include a titanium oxide layer, and the second doped interfacial layer 141b' may include a cobalt oxide layer. In some embodiments, the first interfacial layer 141a may include a titanium oxide layer, and the second doped interfacial layer 141b' may include a titanium oxide layer.

In some embodiments, dopants DP may include a metal that acts as an n-type doping effect. In some embodiments, each of the dopants DP may have a pentavalent valence state. For example, the dopants DP may include nitrogen (N), vanadium (V), copper (Cu), niobium (Nb), tantalum (Ta), antimony (Sb), phosphorus (P), or a combination thereof, but is not limited thereto.

As illustrated in FIG. 2B, the dopants DP may be uniformly distributed in the second doped interfacial layer 141b'. The second doped interfacial layer 141b' including uniformly distributed dopants DP may be deposited by using an atomic layer deposition (ALD) method. Although not shown, in some embodiments, the dopants DP may be included in the second doped interfacial layer 141b' in the form of thin films. For example, the second doped interfacial layer 141b' may have a structure where thin films including dopants DP are attached onto a metal oxide layer forming the second doped interfacial layer 141b'. The second doped interfacial layer 141b' including dopants DP attached in the form of thin films may be deposited using a super cycle method. A more detailed manufacturing process of the second doped interfacial layer 141b' will be described later with reference to FIGS. 7A and 7B.

In some embodiments, to prevent an excessive increase in the equilibrium oxide thickness of the interfacial structure 140b, the total ratio of the high band gap interfacial layer 143a in the interfacial structure 140b may be limited to more than about 0% and less than or equal to about 61% (e.g. more than 0% and less than or equal to 61%). The total ratio of the first interfacial layer 141a and the second doped interfacial layer 141b' in the interfacial structure 140b may be limited to about 39% or more and less than about 100% (e.g. greater than or equal to 39% and less than 100%).

Since the second doped interfacial layer 141b' includes the dopants DP, the equilibrium oxide thickness of the interfacial structure 140b may be reduced, and the degree of integration of the integrated circuit device may be improved.

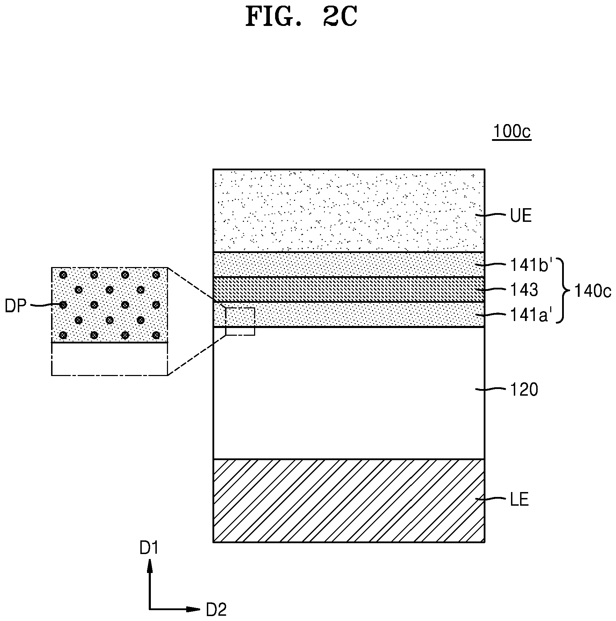

FIG. 2C is a cross-sectional view illustrating a capacitor structure 100c of an integrated circuit device according to some embodiments. Since the capacitor structure 100c is generally similar to the capacitor structure 100a described in FIG. 2A, except that the interfacial structure 140c is included instead of the interfacial structure 140a, the difference between the capacitor structure 100a and the capacitor structure 100c will be mainly described below.

Referring to FIG. 2C, an integrated circuit device may include a capacitor structure 100c formed on a substrate.

The capacitor structure 100c may include a lower electrode LE, a dielectric layer 120 on the lower electrode LE, an upper electrode UE, and an interfacial structure 140c between the dielectric layer 120 and the upper electrode UE. In some embodiments, a thickness of the interfacial structure 140c may be between about 1 Å to about 30 Å (e.g. between 1 Å and 30 Å), between about 1 Å to about 25 Å (e.g. between 1 Å and 25 Å), between about 1 Å to about 20 Å (e.g. between 1 Å and 20 Å), between about 1 Å to about 15 Å (e.g. between 1 Å and 15 Å), between about 1 Å to about 10 Å (e.g. between 1 Å and 10 Å), or between about 1 Å to about 5 Å (e.g. between 1 Å and 5 Å), in the first direction D1.

The interfacial structure 140c may have a multilayer structure including a plurality of layers. In some embodiments, the interfacial structure 140c may include a plurality of doped interfacial layers 141a' and 141b', and a high band gap interfacial layer 143 disposed between the plurality of doped interfacial layers 141a' and 141b'. For example, the first doped interfacial layer 141a' may be arranged on the dielectric layer 120, the high band gap interfacial layer 143 may be arranged on the first doped interfacial layer 141a', and the second doped interfacial layer 141b' may be arranged on the high band gap interfacial layer 143. The first doped interfacial layer 141a' may be disposed between the dielectric layer 120 and the high band gap interfacial layer 143, and the second doped interfacial layer 141b' may be disposed between the high band gap interfacial layer 143 and the upper electrode UE.

The dielectric layer 120 may have a first band gap, each of the doped interfacial layers 141a' and 141b' may have a second band gap, and the high band gap interfacial layer 143 may have a third band gap. In this case, the second band gap of each of the doped interfacial layers 141a' and 141b' may be smaller than the first band gap of the dielectric layer 120, and the third band gap of the high band gap interfacial layer 143 may be larger than the second band gap of each of the doped interfacial layers 141a' and 141b'.

In some embodiments, the first band gap of the dielectric layer 120 and the third band gap of the high band gap interfacial layer 143 may be the same. In some embodiments, the first band gap of the dielectric layer 120 and the third band gap of the high band gap interfacial layer 143 may be different from each other.

In some embodiments, the dielectric layer 120 may include a silicon oxide layer, a silicon nitride layer, or a first metal oxide layer including a first metal. Each of the doped interfacial layers 141a' and 141b' may include a second metal oxide layer including a second metal, and may further include dopants DP. The high band gap interfacial layer 143 may include a third metal oxide layer including a third metal. Each of the dielectric layer 120, the doped interfacial layers 141a' and 141b', and the high band gap interfacial layer 143 may have a single layer structure including one layer or a multilayer structure including a plurality of layers.

In this case, a correlation may be formed in which a band gap of the second metal oxide layer is smaller than that of the first metal oxide layer and a band gap of the third metal oxide layer is larger than that of the second metal oxide layer.

According to the correlation between the band gaps of the first metal oxide layer, the second metal oxide layer, and the third metal oxide layer, the first metal, the second metal, and the third metal may be selected from hafnium (Hf), zirconium (Zr), aluminum (Al), lanthanum (La), tantalum (Ta), yttrium (Y), strontium (Sr), titanium (Ti), cobalt (Co), vanadium (V), copper (Cu), tantalum (Ta), niobium (Nb), tin (Sn), molybdenum (Mo), tungsten (W), barium (Ba), cerium (Ce), and/or a combination thereof, but are not limited thereto.

Details of the first metal, the second metal, and the third metal are substantially the same as those described with respect to the first metal, the second metal, and the third metal in FIG. 1.

For example, each of the doped interfacial layers 141a' and 141b' may include, but is not limited to, a titanium oxide layer, a cobalt oxide layer, a tungsten oxide layer, a vanadium oxide layer, a copper oxide layer, a niobium oxide layer, or a combination thereof. The dielectric layer 120 and the high band gap interfacial layer 143 may include substantially the same material as the material illustrated for configuring the dielectric layer 120 and the high band gap interfacial layer 143 in FIG. 1.

In some embodiments, the first doped interfacial layer 141a' and the second doped interfacial layer 141b' may include different metals. In some embodiments, the first doped interfacial layer 141a' and the second doped interfacial layer 141b' may include the same metal. In some embodiments, the first doped interfacial layer 141a' may include a titanium oxide layer, and the second doped interfacial layer 141b' may include a cobalt oxide layer. In some embodiments, the first doped interfacial layer 141a' may include a titanium oxide layer, and the second doped interfacial layer 141b' may include a titanium oxide layer.

In some embodiments, dopants DP may include a metal that acts as an n-type doping effect. In some embodiments, each of the dopants DP may have a pentavalent valence state. For example, the dopants DP may include nitrogen (N), vanadium (V), copper (Cu), niobium (Nb), tantalum (Ta), antimony (Sb), phosphorus (P), or a combination thereof, but is not limited thereto.

As illustrated in FIG. 2C, the dopants DP may be uniformly distributed in the first doped interfacial layer 141a' and the second doped interfacial layer 141b'. The respective doped interfacial layers 141a' and 141b' including uniformly distributed dopants DP may be deposited by using an atomic layer deposition (ALD) method. Although not shown, in some embodiments, the dopants DP may be included in the doped interfacial layers 141a' and 141b' in the form of thin films. For example, each of the doped interfacial layers 141a' and 141b' may have a structure in which thin films including dopants DP are attached onto a metal oxide layer forming each of the doped interfacial layers 141a' and 141b'. The respective doped interfacial layers 141a' and 141b' including dopants DP attached in the form of thin films may be deposited using a super cycle method. A more detailed manufacturing process of the first doped interfacial layer 141a' and the second doped interfacial layer 141b' will be described later with reference to FIGS. 7A and 7B.

In some embodiments, to prevent an excessive increase in the equilibrium oxide thickness of the interfacial structure 140c, the total ratio of the high band gap interfacial layer 143a in the interfacial structure 140c may be limited to more than about 0% and less than or equal to about 61% (e.g. more than 0% and less than or equal to 61%). The total ratio of each of the interfacial layers 141a' and 141b' in the interfacial structure 140c may be limited to about 39% or more but less than about 100% (e.g. greater than or equal to 39% and less than 100%).

Since each of the doped interfacial layers 141a' and 141b' includes the dopants DP, the equilibrium oxide thickness of the interfacial structure 140c may be further reduced, and the degree of integration of the integrated circuit device may be improved.

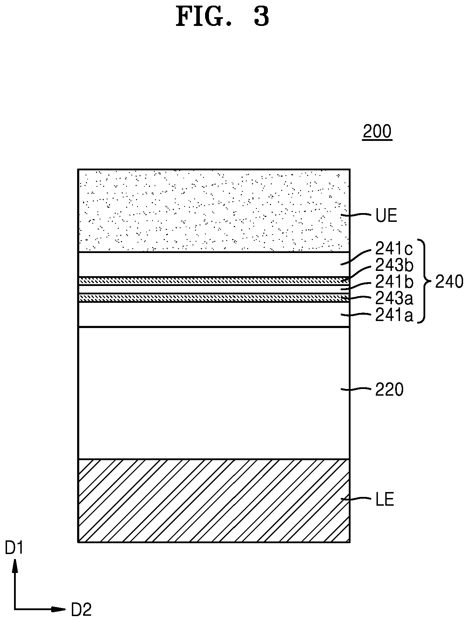

FIG. 3 is a cross-sectional view illustrating a capacitor structure 200 of an integrated circuit device according to some embodiments. Since the capacitor structure 200 is configured to be generally similar to the capacitor structure 100 described in FIG. 1, differences between the capacitor structure 100 and the capacitor structure 200 will be mainly described below.

Referring to FIG. 3, an integrated circuit device may include a capacitor structure 200 formed on a substrate.

The capacitor structure 200 may include a lower electrode LE, a dielectric layer 220 on the lower electrode LE, an upper electrode UE, and an interfacial structure 240 between the dielectric layer 220 and the upper electrode UE.

The interfacial structure 240 may have a multilayer structure including a plurality of layers. In some embodiments, the interfacial structure 240 may include a plurality of interfacial layers, for example, the first interfacial layer 241a, the second interfacial layer 241b, and the third interfacial layer 241c and first high band gap interfacial layer 243a and the second high band gap interfacial layer 243b disposed between a pair of adjacent interfacial layers from among the plurality of interfacial layers. For example, the interfacial structure 240 may include a first high band gap interfacial layer 243a disposed between the first interfacial layer 241a and the second interfacial layer 241b and a second high band gap interfacial layer 243b disposed between the second interfacial layer 241b and the third interfacial layer 241c

The first interfacial layer 241a is positioned at the lowermost part of the interfacial structure 240 may contact the dielectric layer 220, and the third interfacial layer 241c is positioned at the uppermost part of the interfacial structure 240 may contact the upper electrode UE. The interfacial structure 240 is shown to include three layers of the first interfacial layer 241a, the second interfacial layer 241b, and the third interfacial layer 241c and two layers of the first high band gap interfacial layer 243a and the second high band gap interfacial layer 243b, but this is merely an example, and the number of the high band gap interfacial layers is not limited to the illustrated example and may be composed of two or more layers, and the number of the interfacial layers is not limited to the illustrated example and may be composed of three or more layers depending on the number of the high band gap interfacial layers.

The thickness of each of the first interfacial layer 241a, the second interfacial layer 241b, and the third interfacial layer 241c in the first direction D1 is not limited to a case where the thickness of the first interfacial layer 241a located at the lowermost end and the thickness of the third interfacial layer 241c located at the uppermost end in the first direction D1 are thicker than the thickness of the other interfacial layers 241b in the first direction D1, and each of the first interfacial layer 241a, the second interfacial layer 241b, and the third interfacial layer 241c may have various thicknesses in the first direction D1.

The dielectric layer 220 may have a first band gap, each of the first interfacial layer 241a, the second interfacial layer 241b, and the third interfacial layer 241c may have a second band gap, and each of the first high band gap interfacial layer 243a and the second high band gap interfacial layer 243b may have a third band gap. In this case, the second band gap of each of the first interfacial layer 241a, the second interfacial layer 241b, and the third interfacial layer 241c may be smaller than the first band gap of the dielectric layer 220, and the third band gap of each of the first high band gap interfacial layer 243a and the second high band gap interfacial layer 243b may be larger than the second band gap of each of the first interfacial layer 241a, the second interfacial layer 241b, and the third interfacial layer 241c.

In some embodiments, the first band gap of the dielectric layer 220 and the third band gap of each of the first high band gap interfacial layer 243a and the second high band gap interfacial layer 243b may be the same. In some embodiments, the first band gap of the dielectric layer 220 and the third band gap of each of the first high band gap interfacial layer 243a and the second high band gap interfacial layer 243b may be different from each other.

In some embodiments, the dielectric layer 220 may include a silicon oxide layer, a silicon nitride layer, or a first metal oxide layer including a first metal. Each of the first interfacial layer 241a, the second interfacial layer 241b, and the third interfacial layer 241c may include a second metal oxide layer including a second metal. Each of the first high band gap interfacial layer 243a and the second high band gap interfacial layer 243b may include a third metal oxide layer including a third metal. Each of the dielectric layer 220, the first interfacial layer 241a, the second interfacial layer 241b, and the third interfacial layer 241c, and the first high band gap interfacial layer 243a and the second high band gap interfacial layer 243b may have a single layer structure including one layer or a multilayer structure including a plurality of layers.

In this case, a correlation may be formed in which a band gap of the second metal oxide layer is smaller than that of the first metal oxide layer and a band gap of the third metal oxide layer is larger than that of the second metal oxide layer.

According to the correlation between the band gaps of the first metal oxide layer, the second metal oxide layer, and the third metal oxide layer, the first metal, the second metal, and the third metal may be selected from hafnium (Hf), zirconium (Zr), aluminum (Al), lanthanum (La), tantalum (Ta), yttrium (Y), strontium (Sr), titanium (Ti), cobalt (Co), vanadium (V), copper (Cu), tantalum (Ta), niobium (Nb), tin (Sn), molybdenum (Mo), tungsten (W), barium (Ba), cerium (Ce), and/or a combination thereof, but are not limited thereto.

Details of the first metal, the second metal, and the third metal are substantially the same as those described with respect to the first metal, the second metal, and the third metal in FIG. 1.

The dielectric layer 220, each of the first interfacial layer 241a, the second interfacial layer 241b, and the third interfacial layer 241c, and each of the first high band gap interfacial layer 243a and the second high band gap interfacial layer 243b may include substantially the same material as the material illustrated as forming the dielectric layer 120, each of the first interfacial layer 141a and the second interfacial layer 141b, and the high band gap interfacial layer 143 in FIG. 1.

In some embodiments, the first interfacial layer 241a, the second interfacial layer 241b, and the third interfacial layer 241c may include different metals. In some embodiments, the first interfacial layer 241a, the second interfacial layer 241b, and the third interfacial layer 241c may include the same metal. In some embodiments, the first interfacial layer 241a may include a titanium oxide layer, but each of the second interfacial layer 141b and the third interfacial layer 241c may include a cobalt oxide layer. In some embodiments, each of the first interfacial layer 241a, the second interfacial layer 241b, and the third interfacial layer 241c may include a titanium oxide layer.

In some embodiments, the respective first high band gap interfacial layer 243a and the second high band gap interfacial layer 243b may include different metals. In some embodiments, the respective first high band gap interfacial layer 243a and the second high band gap interfacial layer 243b may include the same metal. In some embodiments, the first high band gap interfacial layer 243a may include a tantalum oxide layer, and the second high band gap interfacial layer 243b may include a niobium oxide layer. In some embodiments, each of the first high band gap interfacial layer 243a and the second high band gap interfacial layer 243b may include a tantalum oxide layer.

The effect of the capacitor structure 200 including the first high band gap interfacial layer 243a and the second high band gap interfacial layer 243b is generally similar to that described for the high band gap interfacial layer 143 in FIG. 1.

As the ratio of the first high band gap interfacial layer 243a and the second high band gap interfacial layer 243b in the interfacial structure 240 increases, the equilibrium oxide thickness of the interfacial structure 240 may increase. In some embodiments, to prevent an excessive increase in the equilibrium oxide thickness of the interfacial structure 240, the total ratio of the first high band gap interfacial layer 243a and the second high band gap interfacial layer 243b in the interfacial structure 240 may be limited to more than about 0% and less than or equal to about 61% (e.g. more than 0% and less than or equal to 61%). The total ratio of the first interfacial layer 241a, the second interfacial layer 241b, and the third interfacial layer 241c in the interfacial structure 240 may be limited to about 39% or more and less than about 100% (e.g. greater than or equal to 39% and less than 100%).

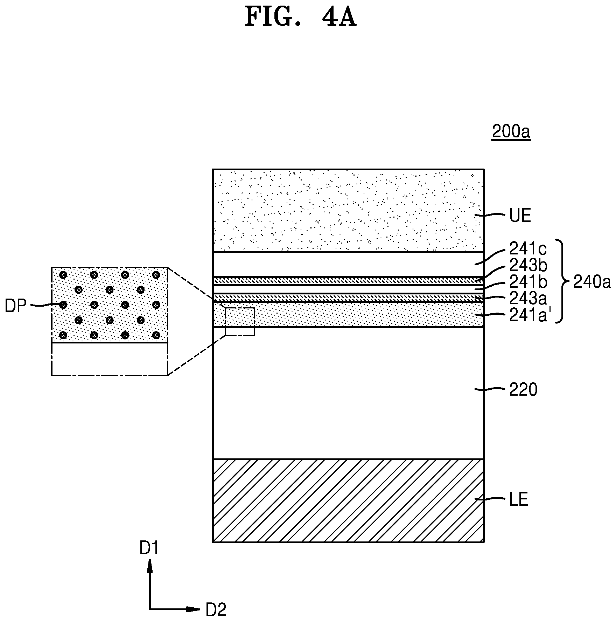

Hereinafter, embodiments in which at least one interfacial layer selected from a plurality of the first interfacial layer 241a, the second interfacial layer 241b, and the third interfacial layer 241c is replaced with a doped interfacial layer including dopants will be described with reference to FIGS. 4A to 4C.

FIG. 4A is a cross-sectional view illustrating a capacitor structure 200a of an integrated circuit device according to some embodiments. Since the capacitor structure 200a is generally similar to the capacitor structure 200 described in FIG. 3, except that the interfacial structure 240a is included instead of the interfacial structure 240, the difference between the capacitor structure 200 and the capacitor structure 200a will be mainly described below.

Referring to FIG. 4A, an integrated circuit device may include a capacitor structure 200a formed on a substrate.

The capacitor structure 200a may include a lower electrode LE, a dielectric layer 220 on the lower electrode LE, an upper electrode UE, and an interfacial structure 240a between the dielectric layer 220 and the upper electrode UE. In some embodiments, a thickness of the interfacial structure 240a may be between about 1 Å to about 30 Å (e.g. between 1 Å and 30 Å), between about 1 Å to about 25 Å (e.g. between 1 Å and 25 Å), between about 1 Å to about 20 Å (e.g. between 1 Å and 20 Å), between about 1 Å to about 15 Å (e.g. between 1 Å and 15 Å), between about 1 Å to about 10 Å (e.g. between 1 Å and 10 Å), or between about 1 Å to about 5 Å (e.g. between 1 Å and 5 Å), in the first direction D1.

The interfacial structure 240a may have a multilayer structure including a plurality of layers. In some embodiments, the interfacial structure 240a may include a first doped interfacial layer 241a', a plurality of interfacial layers, for example, a second interfacial layer 241b and a third interfacial layer 241c, and a plurality of first high band gap interfacial layer 243a and the second high band gap interfacial layer 243b.

In some embodiments, a first high band gap interfacial layer 243a may be disposed between the first doped interfacial layer 241a' and the second interfacial layer 241b, and a second high band gap interfacial layer 243b may be disposed between the second interfacial layer 241b and the third interfacial layer 241c.

In the interfacial structure 240a, the first doped interfacial layer 241a' may contact the dielectric layer 220, and the third interfacial layer 241c may contact the upper electrode UE. The interfacial structure 240 is shown to include one layer of the first doped interfacial layer 241a', two layers of the second interfacial layer 241b and the third interfacial layer 241c, and two layers of the first high band gap interfacial layer 243a and the second high band gap interfacial layer 243b, but this is a non-limiting example, and the number of high band gap interfacial layers may include two or more layers, and the number of interfacial layers may include two or more layers, depending on the number of high band gap interfacial layers.

The thickness of each of the first doped interfacial layer 241a' and the second interfacial layer 241b and the third interfacial layer 241c in the first direction D1 is not limited to a case where the thickness of the first doped interfacial layer 241a' and the thickness of the third interfacial layer 241c in the first direction D1 are thicker than the thickness of the second interfacial layers 241b in the first direction D1, and each of the first doped interfacial layer 241a' and the second interfacial layer 241b and the third interfacial layer 241c may have various thicknesses in the first direction D1.

The dielectric layer 220 may have a first band gap, the first doped interfacial layer 241a' may have a second band gap, the second interfacial layer 241b and the third interfacial layer 241c may have a third band gap, and each of the first high band gap interfacial layer 243a and the second high band gap interfacial layer 243b may have a fourth band gap. In this case, the second band gap of the first doped interfacial layer 241a' and the third band gap of each of the second interfacial layer 241b and the third interfacial layer 241c may be smaller than the first band gap of the dielectric layer 220, and the fourth band gap of each of the first high band gap interfacial layer 243a and the second high band gap interfacial layer 243b may be larger than the second band gap of the first doped interfacial layers 241a' and the third band gap of each of the second interfacial layer 241b and the third interfacial layer 241c.

In some embodiments, the first band gap of the dielectric layer 220 and the fourth band gap of each of the first high band gap interfacial layer 243a and the second high band gap interfacial layer 243b may be the same. In some embodiments, the first band gap of the dielectric layer 220 and the fourth band gap of each of the first high band gap interfacial layer 243a and the second high band gap interfacial layer 243b may be different from each other.

In some embodiments, the dielectric layer 220 may include a silicon oxide layer, a silicon nitride layer, or a first metal oxide layer including a first metal. Each of the first doped interfacial layer 241a' and the second interfacial layer 241b and the third interfacial layer 241c may include a second metal oxide layer including a second metal. Each of the first high band gap interfacial layer 243a and the second high band gap interfacial layer 243b may include a third metal oxide layer including a third metal. Each of the dielectric layer 220, the first doped interfacial layer 241a', the second interfacial layer 241b and the third interfacial layer 241c, and the first high band gap interfacial layer 243a and the second high band gap interfacial layer 243b may have a single layer structure including one layer or a multilayer structure including a plurality of layers.

In this case, a correlation may be formed in which a band gap of the second metal oxide layer is smaller than that of the first metal oxide layer and a band gap of the third metal oxide layer is larger than that of the second metal oxide layer.

According to the correlation between the band gaps of the first metal oxide layer, the second metal oxide layer, and the third metal oxide layer, the first metal, the second metal, and the third metal may be selected from hafnium (Hf), zirconium (Zr), aluminum (Al), lanthanum (La), tantalum (Ta), yttrium (Y), strontium (Sr), titanium (Ti), cobalt (Co), vanadium (V), copper (Cu), tantalum (Ta), niobium (Nb), tin (Sn), molybdenum (Mo), tungsten (W), barium (Ba), cerium (Ce), and/or a combination thereof, but are not limited thereto.

Details of the first metal, the second metal, and the third metal are substantially the same as those described with respect to the first metal, the second metal, and the third metal in FIG. 1.

For example, the first doped interfacial layer 241a' may include, but is not limited to, a titanium oxide layer, a cobalt oxide layer, a tungsten oxide layer, a vanadium oxide layer, a copper oxide layer, a niobium oxide layer, or a combination thereof. Each of the second interfacial layer 241b and the third interfacial layer 241c may include a titanium oxide layer, a cobalt oxide layer, a tungsten oxide layer, a vanadium oxide layer, a copper oxide layer, a niobium oxide layer, or a combination thereof, but is not limited thereto. The dielectric layer 220 and each of the first high band gap interfacial layer 243a and the second high band gap interfacial layer 243b may include substantially the same material as the material illustrated for configuring the dielectric layer 120 and the high band gap interfacial layer 143 in FIG. 1.

In some embodiments, the first doped interfacial layer 241a' and the second interfacial layer 241b and the third interfacial layer 241c may include different metals. In some embodiments, the first doped interfacial layer 241a' and the second interfacial layer 241b and the third interfacial layer 241c may include the same metal.

In some embodiments, the respective first high band gap interfacial layer 243a and the second high band gap interfacial layer 243b may include different metals. In some embodiments, the respective first high band gap interfacial layer 243a and the second high band gap interfacial layer 243b may include the same metal. In some embodiments, the first high band gap interfacial layer 243a may include a tantalum oxide layer, and the second high band gap interfacial layer 243b may include a niobium oxide layer. In some embodiments, each of the first high band gap interfacial layer 243a and the second high band gap interfacial layer 243b may include a tantalum oxide layer.

In some embodiments, dopants DP may include a metal that acts as an n-type doping effect. In some embodiments, each of the dopants DP may have a pentavalent valence state. For example, the dopants DP may include nitrogen (N), vanadium (V), copper (Cu), niobium (Nb), tantalum (Ta), antimony (Sb), phosphorus (P), or a combination thereof, but is not limited thereto.

As illustrated in FIG. 4A, the dopants DP may be uniformly distributed in the first doped interfacial layer 241a'. The first doped interfacial layer 241a' including uniformly distributed dopants DP may be deposited by using an atomic layer deposition (ALD) method. Although not shown, in some embodiments, the dopants DP may be included in the first doped interfacial layer 241a' in the form of thin films. For example, the first doped interfacial layer 241a' may have a structure where thin films including dopants DP are attached onto a metal oxide layer forming the first doped interfacial layer 241a'. The first doped interfacial layer 241a' including dopants DP attached in the form of thin films may be deposited using a super cycle method. A more detailed manufacturing process of the first doped interfacial layer 241a' will be described later with reference to FIGS. 7A and 7B.

The effect of the capacitor structure 200 including the first high band gap interfacial layer 243a and the second high band gap interfacial layer 243b is generally similar to that described for the high band gap interfacial layer 143 in FIG. 1.

In some embodiments, to prevent an excessive increase in the equilibrium oxide thickness of the interfacial structure 240a, the total ratio of the first high band gap interfacial layer 243a and the second high band gap interfacial layer 243b in the interfacial structure 240a may be limited to more than about 0% and less than or equal to about 61% (e.g. more than 0% and less than or equal to 61%). The total ratio of the first doped interfacial layer 241a' and the second interfacial layer 241b and the third interfacial layer 241c in the interfacial structure 240a may be limited to about 39% or more and less than about 100% (e.g. greater than or equal to 39% and less than 100%).

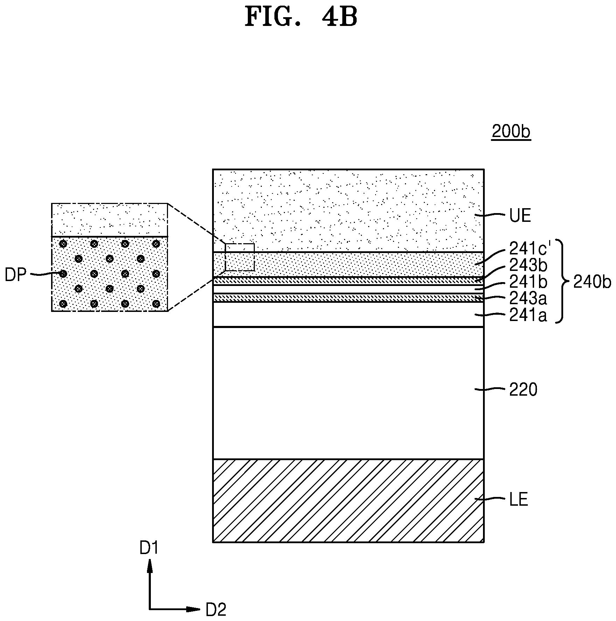

FIG. 4B is a cross-sectional view illustrating a capacitor structure 200b of an integrated circuit device according to some embodiments.

Since the capacitor structure 200b is generally similar to the capacitor structure 200 described in FIG. 3, except that the interfacial structure 240b is included instead of the interfacial structure 240, the difference between the capacitor structure 200 and the capacitor structure 200b will be mainly described below.

Referring to FIG. 4B, an integrated circuit device may include a capacitor structure 200b formed on a substrate.

The capacitor structure 200b may include a lower electrode LE, a dielectric layer 220 on the lower electrode LE, an upper electrode UE, and an interfacial structure 240a between the dielectric layer 220 and the upper electrode UE. In some embodiments, a thickness of the interfacial structure 240b may be between about 1 Å to about 30 Å (e.g. between 1 Å and 30 Å), between about 1 Å to about 25 Å (e.g. between 1 Å and 25 Å), between about 1 Å to about 20 Å (e.g. between 1 Å and 20 Å), between about 1 Å to about 15 Å (e.g. between 1 Å and 15 Å), between about 1 Å to about 10 Å (e.g. between 1 Å and 10 Å), or between about 1 Å to about 5 Å (e.g. between 1 Å and 5 Å), in the first direction D1.

The interfacial structure 240b may have a multilayer structure including a plurality of layers. In some embodiments, the interfacial structure 240b may include a plurality of interfacial layers, for example, the first interfacial layer 241a and the second interfacial layer 241b, a third doped interfacial layer 241c', and a plurality of high band gap interfacial layers, for example, first high band gap interfacial layer 243a and the second high band gap interfacial layer 243b.

In some embodiments, a first high band gap interfacial layer 243a may be disposed between the first interfacial layer 241a and the second interfacial layer 241b, and a second high band gap interfacial layer 243b may be disposed between the second interfacial layer 241b and the third doped interfacial layer 241c'.

The first interfacial layer 241a may contact the dielectric layer 220, and the third doped interfacial layer 241c' may contact the upper electrode UE. The interfacial structure 240b is shown to include two layers of the first interfacial layer 241a and the second interfacial layer 241b, one layer of the third doped interfacial layer 241c', and two layers of the first high band gap interfacial layer 243a and the second high band gap interfacial layer 243b, but this is a non-limiting example, and the number of high band gap interfacial layers may include two or more layers, and the number of interfacial layers may include two or more layers, depending on the number of high band gap interfacial layers.

The thickness of each of the first interfacial layer 241a and the second interfacial layer 241b, and the third doped interfacial layer 241c' in the first direction D1 is not limited to a case where the thickness of the first interfacial layer 241a located at the lowermost end and the thickness of the third doped interfacial layer 241c' located at the uppermost end in the first direction D1 are thicker than the thickness of the other interfacial layers 241b in the first direction D1, and each of the first interfacial layer 241a and the second interfacial layer 241b, and the third doped interfacial layer 241c' may have various thicknesses in the first direction D1.

The dielectric layer 220 may have a first band gap, each of the first interfacial layer 241a and the second interfacial layer 241b may have a second band gap, the third doped interfacial layer 241c' may have a third band gap, and each of the first high band gap interfacial layer 243a and the second high band gap interfacial layer 243b may have a fourth band gap. In this case, the second band gap of each of the first interfacial layer 241a and the second interfacial layer 241b and the third band gap of the third doped interfacial layers 241c' may be smaller than the first band gap of the dielectric layer 220, and the fourth band gap of each of the first high band gap interfacial layer 243a and the second high band gap interfacial layer 243b may be larger than the second band gap of each of the first interfacial layer 241a and the second interfacial layer 241b and the third band gap of the third doped interfacial layer 241c'.

In some embodiments, the first band gap of the dielectric layer 220 and the fourth band gap of each of the first high band gap interfacial layer 243a and the second high band gap interfacial layer 243b may be the same. In some embodiments, the first band gap of the dielectric layer 220 and the fourth band gap of each of the first high band gap interfacial layer 243a and the second high band gap interfacial layer 243b may be different from each other.

In some embodiments, the dielectric layer 220 may include a silicon oxide layer, a silicon nitride layer, or a first metal oxide layer including a first metal. Each of the first interfacial layer 241a and the second interfacial layer 241b and the third doped interfacial layer 241c' may include a second metal oxide layer including a second metal. Each of the first high band gap interfacial layer 243a and the second high band gap interfacial layer 243b may include a third metal oxide layer including a third metal. Each of the dielectric layer 220, the first interfacial layer 241a and the second interfacial layer 241b, the third doped interfacial layer 241c', and the first high band gap interfacial layer 243a and the second high band gap interfacial layer 243b may have a single layer structure including one layer or a multilayer structure including a plurality of layers.

In this case, a correlation may be formed in which a band gap of the second metal oxide layer is smaller than that of the first metal oxide layer and a band gap of the third metal oxide layer is larger than that of the second metal oxide layer.

According to the correlation between the band gaps of the first metal oxide layer, the second metal oxide layer, and the third metal oxide layer, the first metal, the second metal, and the third metal may be selected from hafnium (Hf), zirconium (Zr), aluminum (Al), lanthanum (La), tantalum (Ta), yttrium (Y), strontium (Sr), titanium (Ti), cobalt (Co), vanadium (V), copper (Cu), tantalum (Ta), niobium (Nb), tin (Sn), molybdenum (Mo), tungsten (W), barium (Ba), cerium (Ce), and/or a combination thereof, but are not limited thereto.

Details of the first metal, the second metal, and the third metal are substantially the same as those described with respect to the first metal, the second metal, and the third metal in FIG. 1.

For example, the third doped interfacial layer 241c' may include, but is not limited to, a titanium oxide layer, a cobalt oxide layer, a tungsten oxide layer, a vanadium oxide layer, a copper oxide layer, a niobium oxide layer, or a combination thereof. Each of the first interfacial layer 241a and the second interfacial layer 241b may include a titanium oxide layer, a cobalt oxide layer, a tungsten oxide layer, a vanadium oxide layer, a copper oxide layer, a niobium oxide layer, or a combination thereof, but is not limited thereto. The dielectric layer 220 and each of the first high band gap interfacial layer 243a and the second high band gap interfacial layer 243b may include substantially the same material as the material illustrated for configuring the dielectric layer 120 and the high band gap interfacial layer 143 in FIG. 1.

In some embodiments, each of the first interfacial layer 241a and the second interfacial layer 241b and the third doped interfacial layer 241c' may include different metals. In some embodiments, each of the first interfacial layer 241a and the second interfacial layer 241b and the third doped interfacial layer 241c' may include the same metal.

In some embodiments, the respective first high band gap interfacial layer 243a and the second high band gap interfacial layer 243b may include different metals. In some embodiments, the respective first high band gap interfacial layer 243a and the second high band gap interfacial layer 243b may include the same metal. In some embodiments, the first high band gap interfacial layer 243a may include a tantalum oxide layer, and the second high band gap interfacial layer 243b may include a niobium oxide layer. In some embodiments, each of the first high band gap interfacial layer 243a and the second high band gap interfacial layer 243b may include a tantalum oxide layer.

In some embodiments, dopants DP may include a metal that acts as an n-type doping effect. In some embodiments, each of the dopants DP may have a pentavalent valence state. For example, the dopants DP may include nitrogen (N), vanadium (V), copper (Cu), niobium (Nb), tantalum (Ta), antimony (Sb), phosphorus (P), or a combination thereof, but is not limited thereto.

As illustrated in FIG. 4B, the dopants DP may be uniformly distributed in the third doped interfacial layer 241c'. The third doped interfacial layer 241c' including uniformly distributed dopants DP may be deposited by using an atomic layer deposition (ALD) method. Although not shown, in some embodiments, the dopants DP may be included in the third doped interfacial layer 241c' in the form of thin films. For example, the third doped interfacial layer 241c' may have a structure where thin films including dopants DP are attached onto a metal oxide layer forming the third doped interfacial layer 241c'. The third doped interfacial layer 241c' including dopants DP attached in the form of thin films may be deposited using a super cycle method. A more detailed manufacturing process of the third doped interfacial layer 241c' will be described later with reference to FIGS. 7A and 7B.

The effect of the capacitor structure 200 including the first high band gap interfacial layer 243a and the second high band gap interfacial layer 243b is generally similar to that described for the high band gap interfacial layer 143 in FIG. 1.

In some embodiments, to prevent an excessive increase in the equilibrium oxide thickness of the interfacial structure 240b, the total ratio of the first high band gap interfacial layer 243a and the second high band gap interfacial layer 243b in the interfacial structure 240b may be limited to more than about 0% and less than or equal to about 61% (e.g. more than 0% and less than or equal to 61%). The total ratio of the first interfacial layer 241a, third doped interfacial layer 241c' and the second interfacial layer 241b in the interfacial structure 240b may be limited to about 39% or more and less than about 100% (e.g. greater than or equal to 39% and less than 100%).

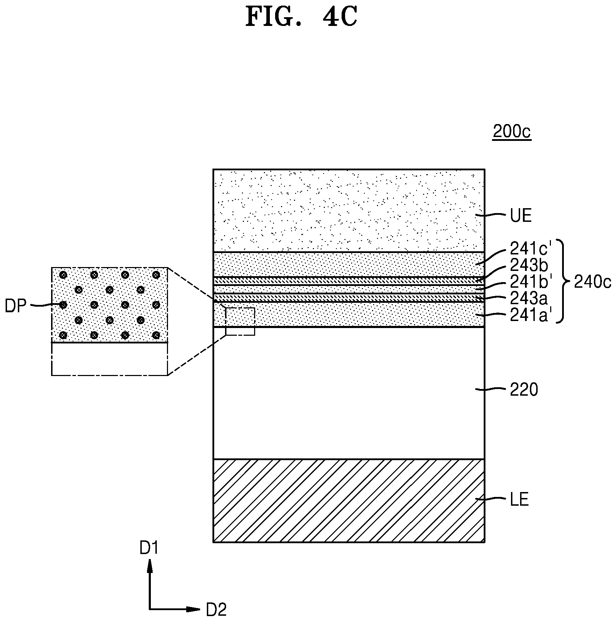

FIG. 4C is a cross-sectional view illustrating a capacitor structure 200c of an integrated circuit device according to some embodiments. Since the capacitor structure 200c is generally similar to the capacitor structure 200 described in FIG. 3, except that the interfacial structure 240c is included instead of the interfacial structure 240, the difference between the capacitor structure 200 and the capacitor structure 200c will be mainly described below.

Referring to FIG. 4C, an integrated circuit device may include a capacitor structure 200c formed on a substrate.

The capacitor structure 200c may include a lower electrode LE, a dielectric layer 220 on the lower electrode LE, an upper electrode UE, and an interfacial structure 240c between the dielectric layer 220 and the upper electrode UE.

The interfacial structure 240c may have a multilayer structure including a plurality of layers. In some embodiments, the interfacial structure 240c may include a plurality of doped interfacial layers, for example, a first doped interfacial layer 241a', a second doped interfacial layer 241b', and a third doped interfacial layer 241c' and first high band gap interfacial layer 243a and the second high band gap interfacial layer 243b disposed between a pair of adjacent doped interfacial layers from among the plurality of doped interfacial layers. For example, the interfacial structure 240c may include a first high band gap interfacial layer 243a disposed between a first doped interfacial layer 241a' and a second doped interfacial layer 241b' and a second high band gap interfacial layer 243b disposed between a second doped interfacial layer 241b' and a third doped interfacial layer 241c'.

The first doped interfacial layer 241a' may contact the dielectric layer 220, and the third doped interfacial layer 241c' may contact the upper electrode UE. The interfacial structure 240c is shown to include three layers of the first doped interfacial layer 241a', the second doped interfacial layer 241b', and the third doped interfacial layer 241c' and two layers of the first high band gap interfacial layer 243a and the second high band gap interfacial layer 243b, but this is merely an example, and the number of the high band gap interfacial layers is not limited to the illustrated example and may be composed of two or more layers, and the number of the doped interfacial layers is not limited to the illustrated example and may be composed of three or more layers depending on the number of the high band gap interfacial layers.

The thickness of each of the plurality of the doped interfacial layers in the first direction D1 is not limited to a case where the thickness of the first doped interfacial layer 241a' and the thickness of the third doped interfacial layer 241c' located in the first direction D1 are thicker than the thickness of the other interfacial layers 241b' in the first direction D1, and each of the plurality of the doped interfacial layers may have various thicknesses in the first direction D1.

The dielectric layer 220 may have a first band gap, each of the first doped interfacial layer 241a', the second doped interfacial layer 241b', and the third doped interfacial layer 241c' may have a second band gap, and each of the first high band gap interfacial layer 243a and the second high band gap interfacial layer 243b may have a third band gap. In this case, the second band gap of each of the first doped interfacial layer 241a', the second doped interfacial layer 241b', and the third doped interfacial layer 241c' may be smaller than the first band gap of the dielectric layer 220, and the third band gap of each of the first high band gap interfacial layer 243a and the second high band gap interfacial layer 243b may be larger than the second band gap of each of the first doped interfacial layer 241a', the second doped interfacial layer 241b', and the third doped interfacial layer 241c'.

In some embodiments, the first band gap of the dielectric layer 220 and the third band gap of each of the first high band gap interfacial layer 243a and the second high band gap interfacial layer 243b may be the same. In some embodiments, the first band gap of the dielectric layer 220 and the third band gap of each of the first high band gap interfacial layer 243a and the second high band gap interfacial layer 243b may be different from each other.

In some embodiments, the dielectric layer 220 may include a silicon oxide layer, a silicon nitride layer, or a first metal oxide layer including a first metal. Each of the first doped interfacial layer 241a', the second doped interfacial layer 241b', and the third doped interfacial layer 241c' may include a second metal oxide layer including a second metal. Each of the first high band gap interfacial layer 243a and the second high band gap interfacial layer 243b may include a third metal oxide layer including a third metal. Each of the dielectric layer 220, the first doped interfacial layer 241a', the second doped interfacial layer 241b', and the third doped interfacial layer 241c', and the first high band gap interfacial layer 243a and the second high band gap interfacial layer 243b may have a single layer structure including one layer or a multilayer structure including a plurality of layers.

In this case, a correlation may be formed in which a band gap of the second metal oxide layer is smaller than that of the first metal oxide layer and a band gap of the third metal oxide layer is larger than that of the second metal oxide layer.

According to the correlation between the band gaps of the first metal oxide layer, the second metal oxide layer, and the third metal oxide layer, the first metal, the second metal, and the third metal may be selected from hafnium (Hf), zirconium (Zr), aluminum (Al), lanthanum (La), tantalum (Ta), yttrium (Y), strontium (Sr), titanium (Ti), cobalt (Co), vanadium (V), copper (Cu), tantalum (Ta), niobium (Nb), tin (Sn), molybdenum (Mo), tungsten (W), barium (Ba), cerium (Ce), and/or a combination thereof, but are not limited thereto.

Details of the first metal, the second metal, and the third metal are substantially the same as those described with respect to the first metal, the second metal, and the third metal in FIG. 1.

Each of the doped interfacial layers 241a', 241b', and 241c may include, but is not limited to, a titanium oxide layer, a cobalt oxide layer, a tungsten oxide layer, a vanadium oxide layer, a copper oxide layer, a niobium oxide layer, or a combination thereof. The dielectric layer 220 and each of the first high band gap interfacial layer 243a and the second high band gap interfacial layer 243b may include substantially the same material as the material illustrated for configuring the dielectric layer 120 and the high band gap interfacial layer 143 in FIG. 1.

In some embodiments, the respective doped interfacial layers 241a', 241b', and 241c' may include different metals. In some embodiments, the respective doped interfacial layers 241a', 241b', and 241c' may include the same metal.

In some embodiments, the respective first high band gap interfacial layer 243a and the second high band gap interfacial layer 243b may include different metals. In some embodiments, the respective first high band gap interfacial layer 243a and the second high band gap interfacial layer 243b may include the same metal. In some embodiments, the first high band gap interfacial layer 243a may include a tantalum oxide layer, and the second high band gap interfacial layer 243b may include a niobium oxide layer. In some embodiments, each of the first high band gap interfacial layer 243a and the second high band gap interfacial layer 243b may include a tantalum oxide layer.

The effect of the capacitor structure 200c including the first high band gap interfacial layer 243a and the second high band gap interfacial layer 243b is generally similar to that described for the high band gap interfacial layer 143 in FIG. 1.

In some embodiments, to prevent an excessive increase in the equilibrium oxide thickness of the interfacial structure 240c, the total ratio of the first high band gap interfacial layer 243a and the second high band gap interfacial layer 243b in the interfacial structure 240c may be limited to more than about 0% and less than or equal to about 61% (e.g. more than 0% and less than or equal to 61%). The total ratio of the first doped interfacial layer 241a', the second doped interfacial layer 241b', and the third doped interfacial layer 241c' in the interfacial structure 240c may be limited to about 39% or more and less than about 100% (e.g. greater than or equal to 39% and less than 100%).

Although the interfacial structures 240a, 240b, and 240c including at least one doped interfacial layer have been described with reference to FIGS. 4A to 4C, the technical idea of the present inventive concept is not limited thereto. In some embodiments, the capacitor structure may include an interfacial structure including two layers of doped interfacial layers or an interfacial structure including four or more layers of doped interfacial layers, or may include a doped interfacial layer disposed between the plurality of first high band gap interfacial layer 243a and the second high band gap interfacial layer 243b.

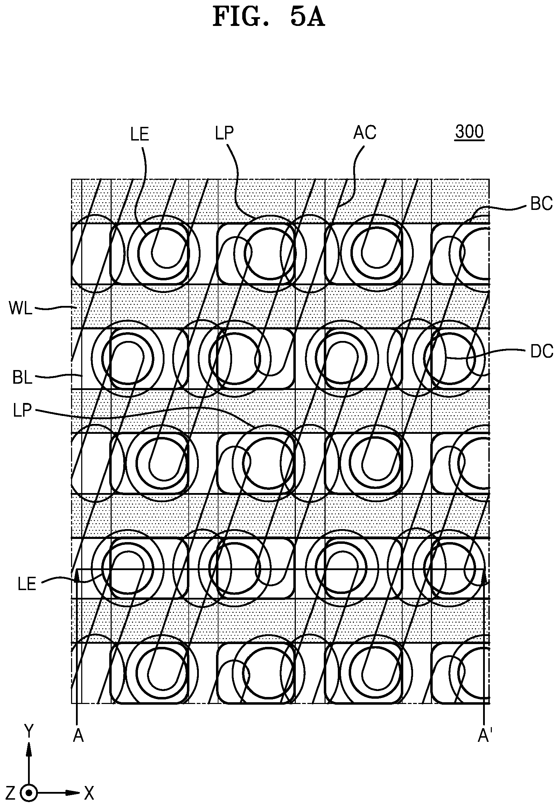

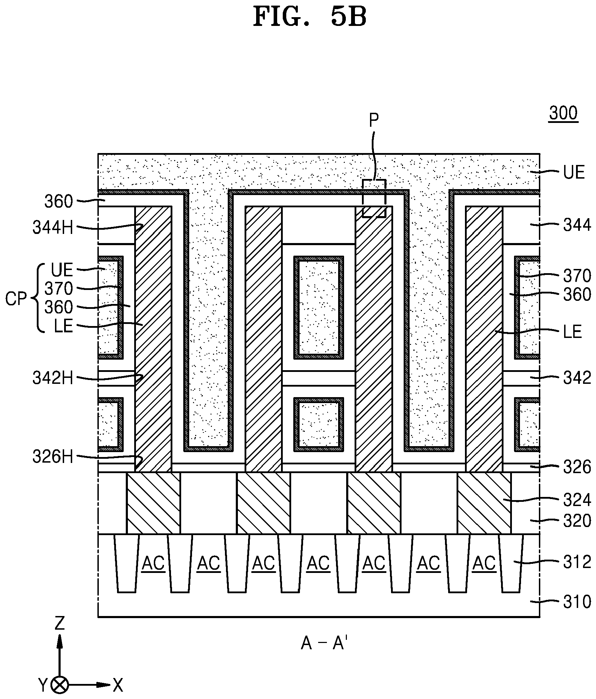

FIG. 5A is a layout diagram illustrating an integrated circuit device according to embodiments. FIG. 5B is a cross-sectional view taken along line A -A' of FIG. 5A.

Referring to FIGS. 5A and 5B, an integrated circuit device 300 may include a capacitor structure CP on a buried channel array transistor (BCAT) structure.

As illustrated in FIG. 5A, the integrated circuit device 300 may include a plurality of active regions AC arranged to horizontally extend in a diagonal direction with respect to a first horizontal direction X and a second horizontal direction Y. A plurality of word lines WL may extend in parallel with each other in the first horizontal direction X across the plurality of active regions AC. A plurality of bit lines BL may extend in parallel with each other in the second horizontal direction Y crossing the first horizontal direction X on the plurality of word lines WL. Each of the plurality of bit lines BL may be connected to an active region AC through a direct contact DC. A plurality of buried contacts BC may be arranged between two bit lines BL adjacent to each other among the plurality of bit lines BL. A plurality of conductive landing pads LP may be arranged on the plurality of buried contacts BC. The plurality of conductive landing pads LP may be arranged to partially overlap the buried contacts BC, respectively. A plurality of lower electrodes LE may be arranged to be spaced apart from each other on the plurality of conductive landing pads LP. The plurality of lower electrodes LE may be connected to a plurality of active regions AC through the plurality of buried contacts BC and the plurality of conductive landing pads LP.

As illustrated in FIG. 5B, the integrated circuit device 300 may include a substrate 310 including the plurality of active regions AC and a lower structure 320 formed on the substrate 310. A plurality of conductive regions 324 may penetrate the lower structure 320 to be connected to the plurality of active regions AC.

The substrate 310 may include a semiconductor element including an element such as Si or Ge, or a compound semiconductor including a compound such as SiC, GaAs, InAs, and InP. The substrate 310 may include a semiconductor substrate, at least one insulating layer formed on the semiconductor substrate, or structures including at least one conductive region. The conductive region may include, for example, an impurity-doped well or an impurity-doped structure. Device isolation layers 312 that define a plurality of active regions AC may be formed on the substrate 310. The device isolation layers 312 may include an oxide layer, a nitride layer, or a combination thereof. In some embodiments, the device isolation layers 312 may have various structures such as a shallow trench isolation (STI) structure.

In some embodiments, the lower structure 320 may include an insulating layer made of a silicon oxide layer, a silicon nitride layer, or a combination thereof. In some embodiments, the lower structure 320 may include various conductive regions, such as wiring layers, contact plugs, transistors, and the like, and an insulating layer that insulates the various conductive regions from each other. The plurality of conductive regions 324 may include polysilicon, metal, conductive metal nitride, metal silicide, or a combination thereof. The lower structure 320 may include the plurality of bit lines BL described with reference to FIG. 5A. Each of the plurality of conductive regions 324 may include the buried contacts BC and the conductive landing pads LP described with reference to FIG. 5A.

An insulating pattern 326 having a plurality of openings 326H overlapping the plurality of conductive regions 324 in the vertical direction Z may be arranged on the lower structure 320 and the plurality of conductive regions 324. The insulating pattern 326 may include a silicon nitride layer (SiN), a silicon carbon nitride layer (SiCN), a silicon boron nitride layer (SiBN), or a combination thereof. As used herein, the terms "SiN", "SiCN", and "SiBN" refer to materials including elements included in each term, and are not chemical formulas representing a stoichiometric relationship.

A lower supporter 342 and an upper supporter 344 overlapping the insulating pattern 326 in the vertical direction Z may be arranged on the insulating pattern 326. The lower supporter 342 extends parallel to the substrate 310 between the substrate 310 and the upper supporter 344 and may be in contact with the outer sidewalls of the plurality of lower electrodes LE. A plurality of holes 342H through which the plurality of lower electrodes LE pass may be formed in the lower supporter 342. The upper supporter 344 may extend in parallel to the substrate 310 while surrounding the upper end portion of each of the plurality of lower electrodes LE. A plurality of holes 344H through which the plurality of lower electrodes LE pass may be formed in the upper supporter 344.

The plurality of lower electrodes LE may extend in the vertical direction Z through the plurality of holes 344H formed in the upper supporter 344 and the plurality of holes 342H formed in the lower supporter 342. An upper surface of each of the plurality of lower electrodes LE and an upper surface of the upper supporter 344 may be coplanar.

The lower supporter 342 and the upper supporter 344 may include a silicon nitride layer (SiN), a silicon carbon nitride layer (SiCN), a silicon boron nitride layer (SiBN), or a combination thereof. In some embodiments, the lower supporter 342 and the upper supporter 344 may include the same material. In some embodiments, the lower supporter 342 and the upper supporter 344 may include different materials. In some examples, each of the lower supporter 342 and the upper supporter 344 may include SiCN. In some examples, the lower supporter 342 may include SiCN, and the upper supporter 344 may include SiBN. However, the technical idea of the present inventive concept is not limited to the materials described above.

A plurality of capacitor structures CP may be arranged on the plurality of conductive regions 324. The plurality of capacitor structures CP may correspond to any one of the capacitor structures 100, 100a, 100b, 100c, 200a, 200b, and 200c described with reference to FIGS. 1, 2A, 2B, 2C, 4A, 4B, and 4C. For example, a region indicated by "P" of the plurality of capacitor structures CP may correspond to those shown in FIGS. 1, 2A, 2B, 2C, 4A, 4B, and 4C.

Each of the plurality of capacitor structures CP may include a lower electrode LE, a dielectric layer 360 covering or overlapping the lower electrode LE, an interfacial structure 370 covering or overlapping the dielectric layer 360, and an upper electrode UE spaced apart from the lower electrode LE with the dielectric layer 360 and the interfacial structure 370 therebetween.

Each of the plurality of lower electrodes LE may have a pillar shape extending lengthwise from the upper surface of the conductive region 324 in a direction away from the substrate 310 in the vertical direction Z through the opening 326H of the insulating pattern 326. The insulating pattern 326 may be arranged adjacent to a lower end of each of the plurality of lower electrodes LE. Although FIG. 5B illustrates a case where each of the plurality of lower electrodes LE has a pillar shape, the technical idea of this inventive concept is not limited thereto. For example, each of the plurality of lower electrodes LE may have a cup shape or a cylindrical cross-sectional structure in which the bottom portion is closed. The plurality of lower electrodes LE may be supported by the lower supporter 342 and the upper supporter 344. As shown in FIG. 5B, the layers of the capacitor structures may be arranged in various orientations, such that each lower electrode LE is surrounded on side surface(s) and a top surface. The arrangements shown in FIGS. 1, 2A, 2B, 2C, 4A, 4B, and 4C are shown with the layers stacked in a first direction D1. This first direction may be a direction perpendicular to a local surface of the lower electrode LE. For instance, D1 may be in a vertical (e.g. Z) direction at a top of the lower electrode LE, and may in a horizontal direction (e.g. a direction perpendicular to the vertical direction) on a side surface of the lower electrode LE.

The lower electrode LE and the upper electrode UE may face each other with the dielectric layer 360 and the interfacial structure 370 therebetween.

The dielectric layer 360 may cover or overlap the upper supporter 344, the lower supporter 342, and lower electrodes LE. The dielectric layer 360 may include portions in contact with the insulating pattern 326, portions in contact with the lower supporter 342, portions in contact with the upper supporter 344, portions in contact with the lower electrode LE, and portions in contact with the interfacial structure 370.

The interfacial structure 370 may be disposed between the dielectric layer 360 and the upper electrode UE. The interfacial structure 370 may correspond to any one of the interfacial structures 140, 140a, 140b, 140c, 240, 240a, 240b, and 240c described with reference to FIGS. 1, 2A to 2C, 3, and 4A to 4C. The interfacial structure 370 may have a multilayer structure including a plurality of interfacial layers and at least one layer of a high band gap interfacial layer.

According to some embodiments of the present inventive concept, since the high band gap interfacial layer having a relatively large band gap is included as described above, leakage current may be reduced, and equilibrium oxide thickness may be relatively reduced by including respective interfacial layers disposed between the dielectric layer 360 and the high band gap interfacial layer and between the upper electrode UE and the high band gap interfacial layer. In addition, since the dielectric layer 360, each interfacial layer, and high band gap interfacial layer have a band gap distribution as described above, the leakage current may be further reduced.

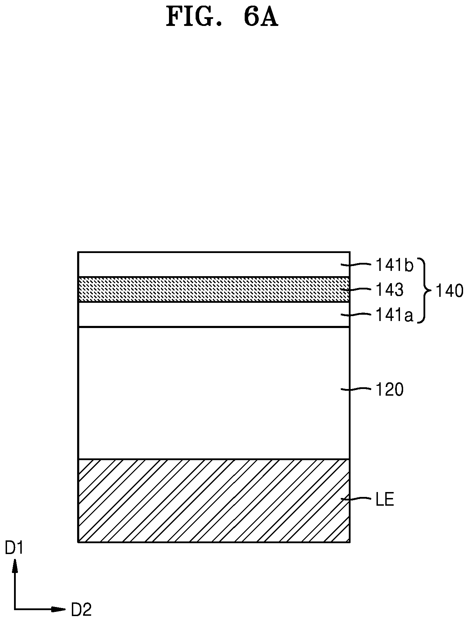

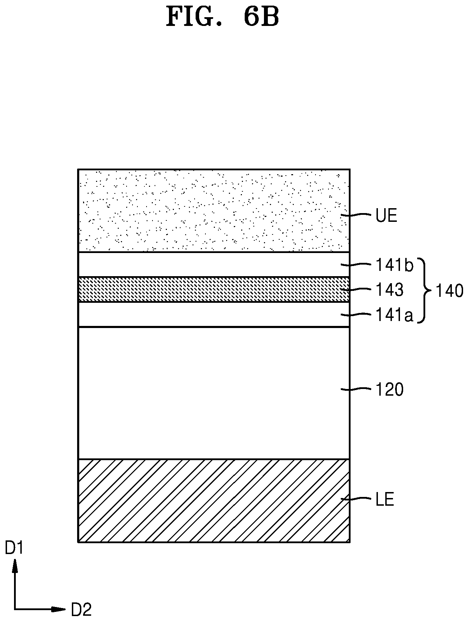

FIGS. 6A and 6B are cross-sectional views illustrating a method of manufacturing a capacitor structure 100 of an integrated circuit device according to some embodiments.

Referring to FIG. 6A, the dielectric layer 120 may be formed on the lower electrode LE. In some embodiments, chemical vapor deposition (CVD), plasma enhanced chemical vapor deposition (PECVD), metal organic vapor deposition (MOCVD), or atomic layer deposition (ALD) may be used to form a lower electrode LE. In some embodiments, CVD, PECVD, MOCVD, or ALD processes may be used to form a dielectric layer 120. When the dielectric layer 120 is formed by a combination of a first precursor and a first reactant, the first precursor may include at least one selected from hafnium (Hf), zirconium (Zr), aluminum (Al), lanthanum (La), tantalum (Ta), and/or yttrium (Y), and the first reactant may include oxygen (O), but are not limited thereto.

An interfacial structure 140 may be formed on the resultant product in which the dielectric layer 120 is formed on the lower electrode LE. In order to form the interfacial structure 140, a first interfacial layer 141a, a high band gap interfacial layer 143, and a second interfacial layer 141b may be sequentially stacked on the dielectric layer 120.

In some embodiments, the first interfacial layer 141a and the second interfacial layer 141b may be formed using an ALD process or a plasma enhanced atomic layer deposition (PEALD) process. In some embodiments, when the first interfacial layer 141a is formed by a combination of a second precursor and a second reactant, a process including a first operation of forming an adsorption layer of the second precursor to form the first interfacial layer 141a on the dielectric layer 120, a second operation of removing unnecessary by-products by supplying a purge gas including an inert gas such as nitrogen or argon to a resultant product in which an adsorption layer of the second precursor is formed, a third operation of supplying the second reactant to the adsorption layer of the second precursor, and a fourth operation of removing unnecessary by-products by supplying the purge gas onto a resultant product by the third operation may be repeatedly performed. For example, the second precursor may include at least one selected from titanium (Ti), cobalt (Co), tungsten (W), vanadium (V), copper (Cu), and niobium (Nb), and/or the second reactant may include oxygen (O), but are not limited thereto.

In some embodiments, the high band gap interfacial layer 143 may be formed using an ALD process or a PEALD process. In some embodiments, when the high band gap interfacial layer 143 is formed by a combination of a third precursor and a third reactant, a process including a first operation of forming an adsorption layer of the third precursor to form the high band gap interfacial layer 143, a second operation of removing unnecessary by-products by supplying a purge gas including an inert gas such as nitrogen or argon to a resultant product in which an adsorption layer of the third precursor is formed, a third operation of supplying the third reactant to the adsorption layer of the third precursor, and a fourth operation of removing unnecessary by-products by supplying the purge gas onto a resultant product by the third operation may be repeatedly performed. For example, the third precursor may include at least one selected from tantalum (Ta), niobium (Nb), tin (Sn), molybdenum (Mo), and/or tungsten (W), and the third reactant may include oxygen (O), but are not limited thereto.

In some embodiments, a process for forming the second interfacial layer 141b again on the resultant product in which the high band gap interfacial layer 143 is formed may be performed. The process for forming the second interfacial layer 141b is similar to the process for forming the first interfacial layer 141a, but a precursor and a reactant different from the precursor and the reactant used to form the first interfacial layer 141a may be used.

Referring to FIG. 6B, the upper electrode UE may be formed on the resultant product of FIG. 6A. To form the upper electrode UE, CVD, PECVD, MOCVD, or ALD processes may be used. In some embodiments, a reducing gas may be used during a deposition process for forming the upper electrode UE.

FIGS. 7A and 7B are cross-sectional views illustrating a method of manufacturing a capacitor structure 100a of an integrated circuit device according to some embodiments. Since the manufacturing method of the capacitor structure 100a described in FIGS. 7A and 7B is generally similar to the manufacturing method of the capacitor structure 100 described in FIGS. 6A and 6B, differences from the manufacturing method of the capacitor structure 100 will be mainly described below.

Referring to FIGS. 7A and 7B, the dielectric layer 120 may be formed on the lower electrode LE. An interfacial structure 140a may be formed on the resultant product in which the dielectric layer 120 is formed on the lower electrode LE. In order to form the interfacial structure 140a, a doped interfacial layer 141a', a high band gap interfacial layer 143, and an interfacial layer 141b may be sequentially stacked on the dielectric layer 120.

In some embodiments, the doped interfacial layer 141a' and the interfacial layers 141b may be formed using an ALD process or a PEALD process.

In some embodiments, when the doped interfacial layer 141a' is formed by a combination of a first precursor, a dopant precursor, and a first reactant, a first process including a first operation of forming an adsorption layer of the first precursor to form the doped interfacial layer 141a' on the dielectric layer 120, a second operation of removing unnecessary by-products by supplying a purge gas including an inert gas such as nitrogen or argon onto a resultant product in which the adsorption layer of the first precursor is formed, a third operation of supplying the dopant precursor to the adsorption layer of the first precursor, a fourth operation of removing unnecessary by-products by supplying the purge gas onto a resultant product by the third operation, a fifth operation of supplying the first reactant to the adsorption layer of the first precursor to which the dopant precursor is combined, and a sixth operation of removing unnecessary by-products by supplying the purge gas onto a resultant product by the fourth operation, and a second process including a first operation of forming the adsorption layer of the first precursor, a second operation of removing unnecessary by-products by supplying the purge gas including an inert gas such as nitrogen or argon to a resultant product in which the adsorption layer of the first precursor is formed, a third operation of supplying the first reactant to the adsorption layer of the first precursor, and a fourth operation of removing unnecessary by-products by supplying the purge gas onto a resultant product by the third operation may be alternately and repeatedly performed. In some embodiments, the second process may be performed after performing the first process. In some embodiments, the first process may be performed after performing the second process. Accordingly, the first doped interfacial layer 141a' in which the dopants DP are uniformly distributed may be formed.

In some embodiments, in order to form the first doped interfacial layer 141a', a super cycle including a first sub-cycle of depositing a metal oxide layer and a second sub-cycle of depositing a thin film made of dopants DP may be repeatedly performed. In some embodiments, when the super cycle is performed once, the first sub cycle may be performed at least once and then the second sub cycle may be performed at least once. Thus, the first doped interfacial layer 141a' in which the dopants DP are deposited in the form of thin films on the metal oxide layer may be formed.

In some embodiments, the high band gap interfacial layer 143 may be formed on the first doped interfacial layer 141a' by using an ALD process or a PEALD process. Thereafter, a process for forming the second interfacial layer 141b on the high band gap interfacial layer 143 may be performed. The process for forming the second interfacial layer 141b is substantially similar to the process for forming the first interfacial layer 141a and the second interfacial layer 141b described in FIG. 6B.

Referring to FIG. 7B, the upper electrode UE may be formed on the resultant product of FIG. 7A. To form the upper electrode UE, CVD, PECVD, MOCVD, or ALD processes may be used. In some embodiments, a reducing gas may be used during a deposition process for forming the upper electrode UE.

In order to form the capacitor structure 100b of FIG. 2B, a process for forming a second doped interfacial layer 141b' on the high band gap interfacial layer 143 may be performed, similar to the process for forming the first doped interfacial layer 141a' described with reference to FIG. 7A.

In order to form the capacitor structure 100c of FIG. 2C, a process for forming a plurality of doped interfacial layers 141a' and 141b' may be performed similarly to the process of forming the first doped interfacial layer 141a' described with reference to FIG. 7A.

In order to form the capacitor structure 200 of FIG. 3, a process of forming the first interfacial layer 141a, the high band gap interfacial layer 143, and the second interfacial layer 141b described with reference to FIG. 6A may be repeatedly performed.

In order to form the capacitor structure 200a of FIG. 4A, the capacitor structure 200b of FIG. 4B, and the capacitor structure 200c of FIG. 4C, a process for forming each of the doped interfacial layers 241a', 241b', and 241c' may be performed similarly to the process of forming the first doped interfacial layers 141a' described with reference to FIG. 7A.

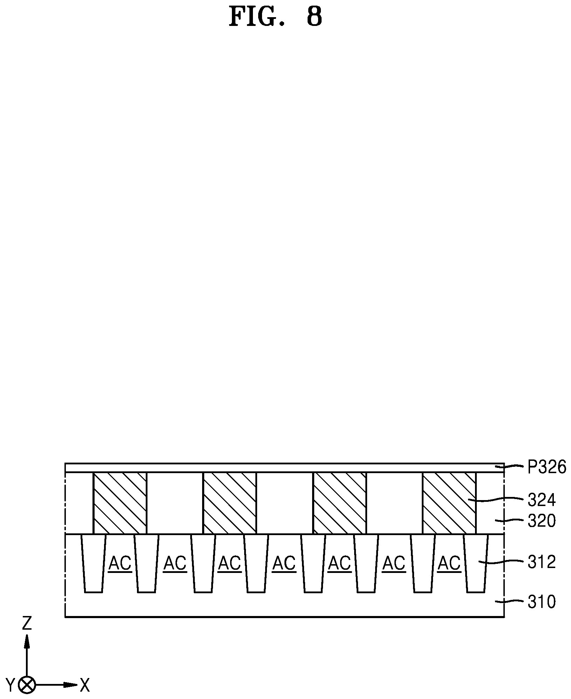

FIGS. 8 to 14 are cross-sectional views illustrating a process order to explain a method of manufacturing an integrated circuit device 300 according to some embodiments of the present inventive concept.

Referring to FIG. 8, a lower structure 320 and conductive regions 324 connected to active regions AC by penetrating the lower structure 320 may be formed on a substrate 310 in which the active regions AC are defined by device isolation layers 312. Then, an insulating layer P326 covering or overlapping the lower structure 320 and the conductive regions 324 may be formed.

The insulating layer P326 may be used as an etching stop layer in a subsequent process. The insulating layer P326 may include an insulating material having etch selectivity with respect to the lower structure 320. In some embodiments, the insulating layer P326 may include a silicon nitride layer (SiN), a silicon carbon nitride layer (SiCN), a silicon boron nitride layer (SiBN), or a combination thereof.

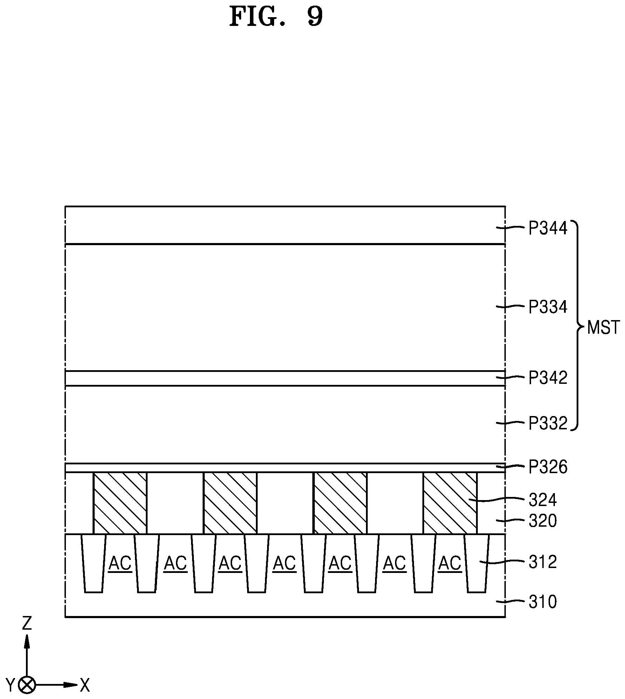

Referring to FIG. 9, a mold structure MST may be formed on the insulating layer P326. The mold structure MST may include a plurality of mold layers and a plurality of support layers. For example, the mold structure MST may include a first mold layer P332, a lower supporter layer P342, a second mold layer P334, and an upper supporter layer P344, which are sequentially stacked on the insulating layer P326. Each of the first mold layer P332 and the second mold layer P334 may include a material that may be removed by a lift-off process using an etchant because the etchant has a relatively high etch rate compared to an etchant including ammonium fluoride (NH₄F), hydrofluoric acid (HF), and/or water.

In some embodiments, each of the first mold layer P332 and the second mold layer P334 may include an oxide layer, a nitride layer, or a combination thereof. For example, the first mold layer P332 may include a boro phospho silicate glass (BPSG) layer. The BPSG layer may include at least one of a first part in which the concentration of dopant boron (B) is varied in the thickness direction of the BPSG layer and a second part in which the concentration of dopant phosphorus (P) is varied in the thickness direction of the BPSG layer. The second mold layer P334 may include a multi-insulating layer in which a relatively thin silicon oxide layer and a silicon nitride layer are alternately repeatedly stacked one by one, or a silicon nitride layer. However, the constituent materials of each of the first mold layer P332 and the second mold layer P334 are not limited to the above examples, and various modifications and changes are possible within the scope of the technical idea of the present inventive concept. In addition, the stacking order of the mold structures MST is not limited to that illustrated in FIG. 9, and various modifications and changes are possible within the scope of the technical idea of this inventive concept.

Each of the lower supporter layer P342 and the upper supporter layer P344 may include a silicon nitride layer (SiN), a silicon carbon nitride layer (SiCN), a silicon boron nitride layer (SiBN), or a combination thereof. In some embodiments, the lower supporter layer P342 and the upper supporter layer P344 may include the same material. In some embodiments, the lower support layer P342 and the upper support layer P344 may include different materials. In an example, each of the lower supporter layer P342 and the upper supporter layer P344 may include a silicon carbon nitride layer. In some examples, the lower supporter layer P342 may include a silicon carbon nitride layer, and the upper supporter layer P344 may include a boron-containing or boron-including silicon nitride layer. However, the constituent materials of the lower support layer P342 and the upper support layer P344 are not limited to the above examples, and various modifications and changes are possible within the scope of the technical idea of the present inventive concept.

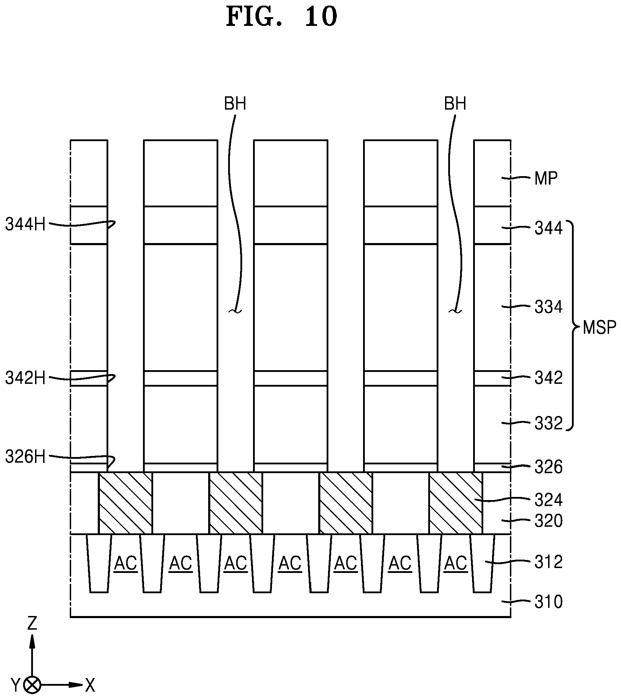

Referring to FIG. 10, in the result of FIG. 9, a mask pattern MP may be formed on the mold structure MST, and then the mold structure MST may be anisotropically etched using the mask pattern MP as an etch mask and the insulating layer P326 as an etch stop layer to form a mold structure pattern MSP that limits a plurality of holes BH. The mold structure pattern MSP may include a first mold pattern 332, a lower supporter 342, a second mold pattern 334, and an upper supporter 344.

The mask pattern MP may include a nitride layer, an oxide layer, a polysilicon layer, a photoresist layer, or a combination thereof.

The process for forming the plurality of holes BH may further include a process of wet-treating a result obtained by anisotropically etching the mold structure MST. While performing the process of anisotropically etching the mold structure MST and wet-treating the resultant, a part of the insulating layer P326 may also be etched to obtain an insulating pattern 326P having a plurality of openings 326H exposing the plurality of conductive regions 324. In a process for wet-treating the result of anisotropic etching of the mold structure MST, an etchant made of a diluted sulfuric acid peroxide (DSP) solution may be used, but is not limited thereto.

In the mold structure pattern MSP, a plurality of holes 342H that are part of the plurality of holes BH may be formed in the lower supporter 342, and a plurality of holes 344H that are part of the plurality of holes BH may be formed in the upper supporter 344.

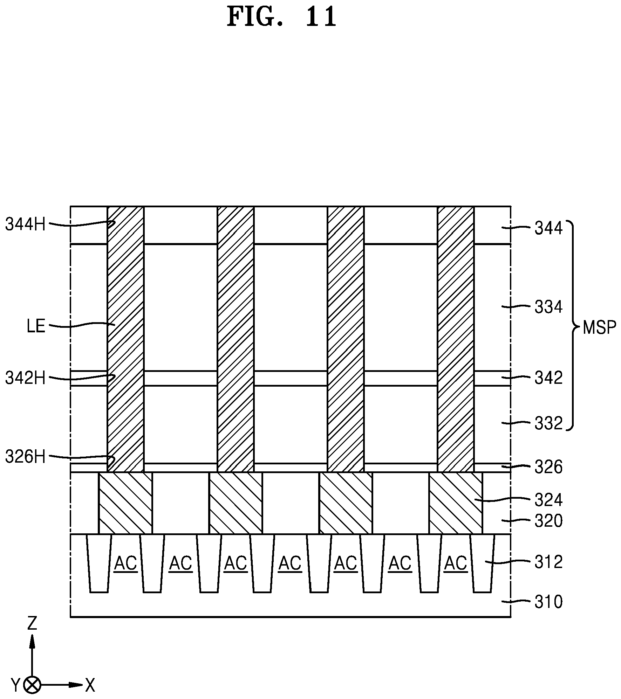

Referring to FIG. 11, the mask pattern MP may be removed from the result of FIG. 10 and lower electrodes LE filling the plurality of holes BH may be formed.

In some embodiments, a conductive layer covering or overlapping the top surface of the upper supporter 344 may be formed while filling the plurality of holes BH on the resultant product of FIG. 10 to form the lower electrodes LE. To form the conductive layer, CVD, PECVD, MOCVD, or ALD processes may be used. Thereafter, a part of the conductive layer may be removed using an etchback process or a chemical mechanical polishing (CMP) process to expose the top surface of the upper supporter 344.

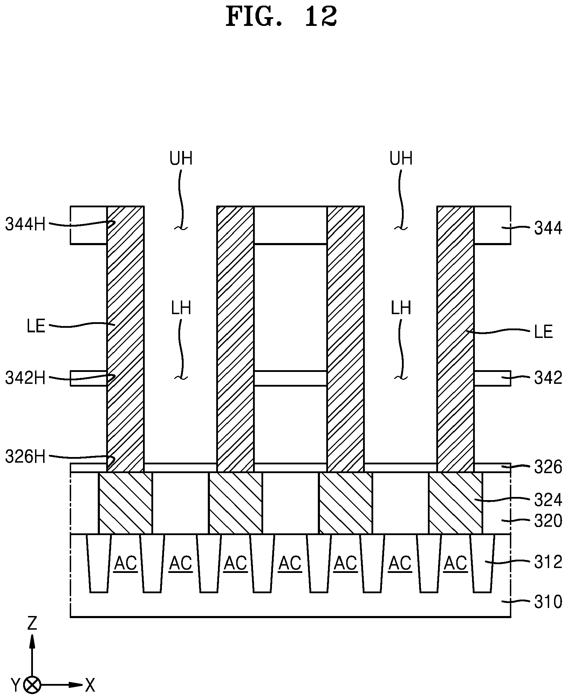

Referring to FIG. 12, a portion of the upper supporter 344 may be removed from the result of FIG. 11 to form a plurality of upper holes UH, and then the second mold pattern 334 may be wetly removed through the plurality of upper holes UH. Thereafter, a portion of the lower supporter 342 exposed through the plurality of upper holes UH is removed to form a plurality of lower holes LH, and the first mold pattern 332 is wetly removed through the plurality of lower holes LH to expose the top surface of the insulating pattern 326. After the first mold pattern 332 and the second mold pattern 334 are removed, sidewalls of the plurality of lower electrodes LE may be exposed.

In some embodiments, an etchant including ammonium fluoride (NH₄F), hydrofluoric acid (HF), and/or water may be used to wetly remove the second mold pattern 334 and the first mold pattern 332, but is not limited thereto.

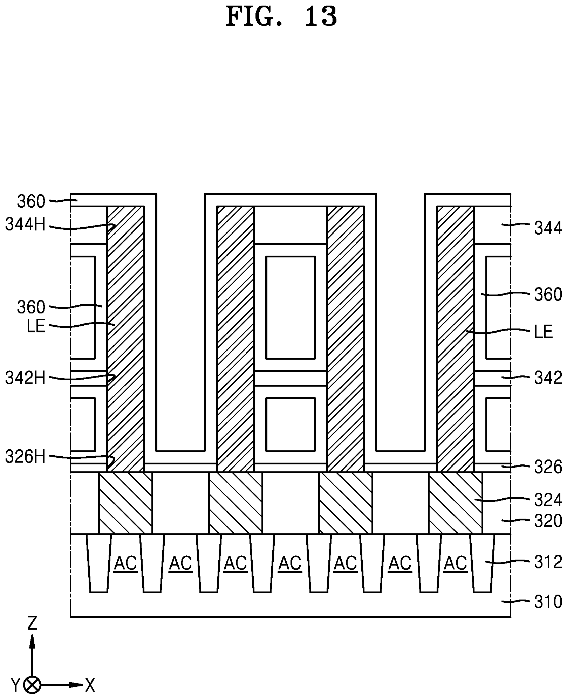

Referring to FIG. 13, a process of forming a dielectric layer 360 covering or overlapping the lower electrodes LE exposed in the resultant product of FIG. 12 may be performed. The dielectric layer 360 may be formed to cover or overlap not only the sidewalls of the lower electrodes LE, but also the exposed surfaces of each of the lower supporter 342 and the upper supporter 344, and the exposed surfaces of the insulating pattern 326. CVD, PECVD, MOCVD, or ALD processes may be used to form the dielectric layer 360. When the dielectric layer 120 is formed by a combination of a first precursor and a first reactant, the first precursor may include at least one selected from hafnium (Hf), zirconium (Zr), aluminum (Al), lanthanum (La), tantalum (Ta), and/or yttrium (Y), and the first reactant may include oxygen (O), but are not limited thereto.

After a deposition process for the dielectric layer 360 covering or overlapping the lower electrodes LE is performed, an annealing process may be performed. In some embodiments, the annealing process may be performed under temperature of about 200 °C to about 700 °C. Crystallinity of the dielectric layer 360 may be improved by the annealing process that may be performed while the dielectric layer 360 is formed.

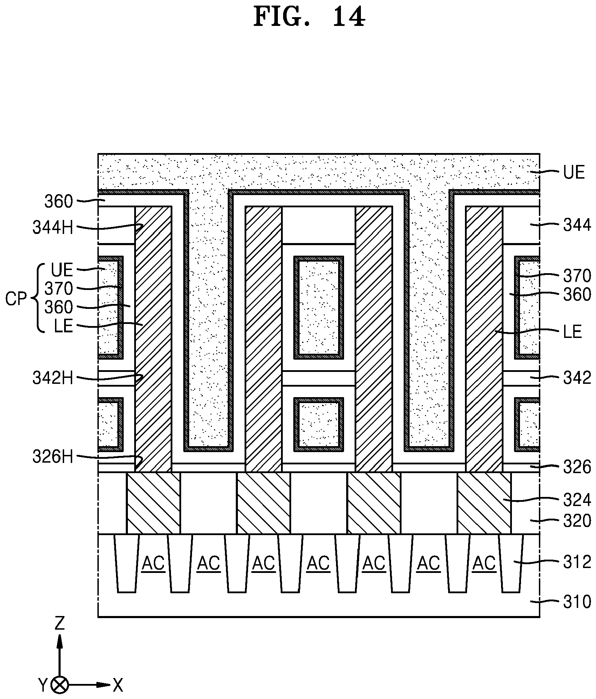

Referring to FIG. 14, the interfacial structure 370 covering or overlapping the dielectric layer 360 may be formed in the resultant product of FIG. 13. The interfacial structure 370 may correspond to any one of the interfacial structures 140, 140a, 140b, 140c, 240, 240a, 240b, and 240c described with reference to FIGS. 1, 2A, 2B, 2C, 3, 4A, 4B, and 4C. That is, the interfacial structure 370 may have a multilayer structure consisting of a plurality of interfacial layers and at least one high band gap interfacial layer. To form the interfacial structure 370, an ALD process or a PEALD process may be used. A specific process of forming the interfacial structure 370 is similar to that described in the process of forming the interfacial structure 140 of FIGS. 6A and 6B or the interfacial structure 140a of FIGS. 7A and 7B.

In some embodiments, the annealing process described in FIG. 13 may be performed after a process of forming the interfacial structure 370. Subsequently, after the interfacial structure 370 is formed, an upper electrode UE may be formed on the interfacial structure 370. In some embodiments, CVD, MOCVD, PVD, or ALD processes may be used to form the upper electrode UE.

While the present inventive concept has been particularly shown and described with reference to embodiments thereof, it will be understood that various changes in form and details may be made therein without departing from the scope of the following claims.

## Claims

1. An integrated circuit device comprising:
a lower electrode;
a dielectric layer on the lower electrode;
an upper electrode facing the lower electrode with the dielectric layer therebetween; and
an interfacial structure between the dielectric layer and the upper electrode, wherein the interfacial structure comprises:
a first interfacial layer comprising a first material composition having a first band gap and a second interfacial layer comprising a second material composition having a second band gap; and
a high band gap interfacial layer between the first interfacial layer and the second interfacial layer, the high band gap interfacial layer comprising a third material composition having a third band gap,
wherein the third band gap of the high band gap interfacial layer is greater than the first band gap of the first interfacial layer and is greater than the second band gap of the second interfacial layer.

2. The integrated circuit device of claim 1, wherein the first band gap of the first interfacial layer and the second band gap of the second interfacial layer are less than a fourth band gap of the dielectric layer.

3. The integrated circuit device of claim 1 or claim 2, wherein the dielectric layer comprises a silicon oxide layer or a first metal oxide layer comprising a first metal, and
wherein the first metal includes at least one of hafnium, zirconium, aluminum, lanthanum, tantalum, or yttrium.

4. The integrated circuit device of any preceding claim, wherein the first interfacial layer and the second interfacial layer each comprise a second metal oxide layer comprising a second metal,
wherein the high band gap interfacial layer comprises a metal oxide layer comprising a third metal, and
wherein each of the second metal and the third metal is of hafnium, zirconium, aluminum, lanthanum, tantalum, yttrium, strontium, titanium, cobalt, vanadium, copper, tantalum, niobium, tin, molybdenum, tungsten, barium, cerium or a combination thereof to provide a band gap distribution of the first interfacial layer, the second interfacial layer, and the high band gap interfacial layer.

5. The integrated circuit device of any preceding claim, wherein the first band gap of the first interfacial layer and the second band gap of the second interfacial layer are each about 1.0 eV or more but less than about or equal to 3.5 eV.

6. The integrated circuit device of any preceding claim, wherein the first interfacial layer and the second interfacial layer each comprise a second metal oxide layer comprising a second metal, and
wherein the second metal comprises at least one of titanium, cobalt, tungsten, vanadium, copper, or niobium.

7. The integrated circuit device of any preceding claim, wherein the high band gap interfacial layer comprises a metal oxide layer having the third band gap of 3.5 eV to 9.0 eV.

8. The integrated circuit device of any preceding claim, wherein the high band gap interfacial layer comprises a metal oxide layer comprising a third metal, and
wherein the third metal comprises at least one of tantalum, niobium, tin, molybdenum, or tungsten.

9. The integrated circuit device of any preceding claim, wherein a percentage of the third material composition of the high band gap interfacial layer in the interfacial structure is greater than 0% and less than or equal to 61%, and
wherein a total percentage of the first material composition of the first interfacial layer and the second material composition of the second interfacial layer in the interfacial structure is greater than or equal to 39% and less than 100%.

10. The integrated circuit device of any preceding claim, wherein the upper electrode comprises a conductive metal nitride layer.

11. An integrated circuit device comprising:
a lower electrode;
a dielectric layer on the lower electrode;
an upper electrode facing the lower electrode with the dielectric layer therebetween; and
an interfacial structure between the dielectric layer and the upper electrode, wherein the interfacial structure comprises:
a first doped interfacial layer comprising a first material composition having a first band gap and including a first metal oxide layer comprising a first dopant; and
a high band gap interfacial layer on the first doped interfacial layer and comprising a second material composition having a second band gap greater than the first band gap of the first material composition of the first doped interfacial layer,
wherein the first doped interfacial layer has one surface in contact with the dielectric layer or the upper electrode.

12. The integrated circuit device of claim 11, further comprising:
an interfacial layer spaced apart from the first doped interfacial layer with the high band gap interfacial layer therebetween,
wherein the interfacial layer includes a metal oxide layer.

13. The integrated circuit device of claim 11, further comprising:
a second doped interfacial layer spaced apart from the first doped interfacial layer with the high band gap interfacial layer therebetween,
wherein the second doped interfacial layer comprises a second metal oxide layer comprising a second dopant.

14. The integrated circuit device of any of claims 11-13, wherein the first dopant included in the first metal oxide layer of the first doped interfacial layer has a pentavalent valence state.

15. An integrated circuit device comprising:
a lower electrode;
a dielectric layer on the lower electrode and including a silicon oxide layer or a first metal oxide layer comprising a first metal;
an upper electrode facing the lower electrode with the dielectric layer therebetween; and
an interfacial structure between the dielectric layer and the upper electrode, wherein the interfacial structure comprises:
a plurality of second metal oxide layers including a second metal; and
a plurality of third metal oxide layers between a pair of adjacent second metal oxide layers among the plurality of second metal oxide layers and including a third metal,
wherein the plurality of third metal oxide layers comprise material compositions having a band gap of 3.5 eV to 9.0 eV.
